# EUROPEAN PATENT SPECIFICATION

(11) **EP 0 403 552 B1**
(45) Date of publication and mention of the grant of the patent: **14.12.1994**
(21) Application number: 89903867.3
(22) Date of filing: 25.08.1988
(51) Int. Cl.: C23C 14/32

(54) **PHYSICAL VAPOR DEPOSITION DUAL COATING APPARATUS AND PROCESS**
PHYSIKALISCHE DAMPFNIEDERSCHLAG-DOPPELBESCHICHTUNGSVORRICHTUNG UND VERFAHREN
APPAREIL ET PROCEDE DE REVETEMENT DOUBLE PAR DEPOSITION EN PHASE GAZEUSE PAR PROCEDE PHYSIQUE

(43) Date of publication of application: 27.12.1990
(73) Proprietor: HAUZER INDUSTRIES BV, NL-2900 AE VENLO (NL)
(72) Inventor: RANDHAWA, Harbhajan, S., / (US); BUSKE, Jeffrey, M., Boulder, CO 80302 (US)
(74) Representative: Lucas, Brian Ronald
(86) International application number: US8802950
(87) International publication number: WO9002216

(56) References cited:
- DE-A- 3 815 006
- US-A- 4 234 622
- US-A- 4 500 408
- US-A- 4 560 462
- US-A- 4 648 952
- US-A- 4 877 505

## Description

### FIELD OF THE INVENTION

The present invention relates to vacuum coating production system utilizing both cathodic arc emission and magnetron sputtering processes.

### BACKGROUND OF THE INVENTION

### Sputtering Processes.

Over the past 30 years or so there have been numerous reviews of sputtering and sputtering processes for film deposition.

Because there are so many interactions among parameters in sputtering systems, it is impossible to separate them completely.

Typically, the target (a plate of the material to be deposited or the material from which a film is to be synthesized) is connected to a negative DC voltage supply (or an RF power supply). The substrate is the material to be coated and it faces the target. The substrate may be grounded, floating, biased, heated, cooled, or some combination of these. A gas is introduced to provide a medium in which a glow discharge can be initiated and maintained. Gas pressures ranging from a few tenths of Pascals (millitorr) to several Pascals (tens of millitorr) are used. The most common sputtering gas is argon.

When the glow discharge is started, positive ions strike the target plate and remove mainly neutral target atoms by momentum transfer, and these condense on the substrate to form thin films. There are, in addition, other particles and radiation produced at the target, all of which may affect film properties (secondary electrons and ions, desorbed gases, x-rays, and photons). The electrons and negative ions are accelerated toward the substrate platform and bombard it and the growing film. In some instances, a bias potential (usually negative) is applied to the substrate holder, so that the growing film is subject to positive ion bombardment. This is known variously as bias sputtering or ion plating.

In some cases, gases or gas mixtures other than Ar are used. Usually this involves some sort of reactive sputtering process in which a compound is synthesized by sputtering a metal target (e.g., Ti) in a reactive gas (e.g., O₂ or Ar-O₂ mixtures) to form a compound of the metal and the reactive gas species (e.g., TiO₂).

### Emission of Neutral Particles-The Sputtering Yield.

The sputtering yield is defined as the number of atoms ejected from a target surface per incident ion. It is the most fundamental parameter of sputtering processes. Yet all of the surface interaction phenomena involved that contribute to the yield of a given surface are not completely understood. Despite this, an impressive body of literature exists showing the yield to be related to momentum transfer from energetic particles to target surface atoms.

It is estimated that 1% of the energy incident on a target surface goes into ejection of sputtered particles, 75% into heating of the target and the remainder is dissipated by secondary electrons that bombard and heat the substrates. An improved process called magnetron sputtering uses magnetic fields to conduct electrons away from the substrate surface thereby reducing the heat.

There are three basic effects that occur at a substrate during glow discharge sputtering: (1) condensation of energetic vapor, (2) heating, and (3) bombardment by a variety of energetic species. The sum of all of these effects must be, carefully controlled, and, since they are all interdependent, this is sometimes difficult.

For a given target material both deposition rate and uniformity are influenced by system geometry, target voltage, sputtering gas, gas pressure, and power. All other things being equal, rates are linearly proportional to power and decrease with increasing target-substrate separation. The sputtering gas influences deposition rate in the same way as it affects sputtering yields. As the gas pressure is increased the discharge current increases (increasing rate), but return of material to the target by backscattering also increases (decreasing rate). This is further complicated in some cases by increased Penning ionization at higher pressures which increases the rate by self-sputtering. The sum of all of this leads to gas pressure or a small range of gas pressure at which the rate is a maximum, and this must be determined empirically for each application. The optimum pressure may be anywhere between a few tenths of Pascals (mTorr) and a few Pascals (several tens of mTorr).

In general, for a given gas pressure there will be an optimum target-substrate separation to produce the best uniformity. For small targets (15 cm diameter) this separation is generally small (a few centimeters), while for larger targets, the optimum separation may be considerably larger (10-20 cm).

Unquestionably, the hallmark of the sputtering processes described is versatility, both in terms of materials that can be deposited and process parameters that can be adjusted to tailor the properties of thin films as desired. However, the sheer number of critical process parameters and their complex interrelationships can often make these processes difficult to control. In general, these processes are found to be most useful in applications requiring rather thin films (generally 1 µm because of relatively low deposition rates) and/or in cases where the desired material simply cannot be deposited stoichiometrically any other way.

The above portion of this patent application was reprinted with permission from the publishers of Thin Film Processes, edited by John L. Vossen and Werner Kern (copyright Academic Press, Inc., New York, 1978, pp. 12-62).

### Cathodic Arc Plasma Deposition.

In the past ten years major advancements have been made in a related physical deposition process called cathodic arc plasma deposition (CAPD).

In the CAPD process target material is evaporated by the action of vacuum arcs. The target source material is the cathode in the arc circuit. The basic components of a CAPD system consist of a vacuum chamber, a cathode and an arc power supply, a means of igniting an arc on the cathode surface, an anode, a substrate and a substrate bias power supply. Arcs are sustained by voltages typically in the range of 15 - 50 V, depending on the target cathodic material employed. Typical arc currents in the range of 30 - 400 A are employed. Arcing is initiated by the application of a high voltage pulse to an electrode placed near the cathode (gas discharge ignition) and/or by mechanical ignition. The evaporation occurs as a result of the cathodic arc spots which move randomly on the surface of the cathode at speeds typically of the order of 10² m/s. The arc spot motion can also be controlled with the help of appropriate confinement boundaries and/or magnetic fields. The arc spots are sustained owing to material plasma generated with the arc itself. The target cathodic material can be a metal, a semiconductor or an insulator.

The CAPD process is markedly different from other physical vapor deposition (PVD) processes. Some of the characteristic features of the CAPD process are as follows.
(i) The core of the CAPD process is the arc spot which generates material plasma.
(ii) A high percentage (30% - 100%) of the material evaporated from the cathode surface is ionized.
(iii) The ions exist in multiple charge states in the plasma, e.g. Ti, Ti⁺, Ti⁺² and Ti⁺³ etc.
(iv) The kinetic energies of the ions are typically in the range 10-100 eV.

These features result in deposits that are of superior quality compared with those from other physical vapor deposition processes. Some of these advantages are as follows.
(a) Good quality films over a wide range of deposition conditions, e.g. stoichiometric compound films with superior adhesion and high density, can be obtained over a wide range of reactive gas pressure and metal/refractory evaporation rates.
(b) High deposition rates for metals, alloys and compounds with excellent coating uniformity.
(c) Low substrate temperatures.
(d) Retention of alloy composition from source to deposits.
(e) Ease in deposition of compound films.

### Cathodic Arc Emission Characteristics.

The cathodic arc results in a plasma discharge within the material vapor released from the cathode surface. The arc spot is typically a few micrometers in size and carries current densities as high as 10 amps per square micrometer. This high current density causes flash evaporation of the source material and the resulting evaporant consists of electrons, ions, neutral vapor atoms and microdroplets. The electrons are accelerated toward the cloud of positive ions. The emissions from the cathode spots are relatively constant over a wide range of arc current as the cathode spots split into a number of spots. The average current carried per spot depends on the nature of the cathode material.

It is likely that almost 100% of the material may be ionised within the cathode spot region. These ions are ejected in a direction almost perpendicular to the cathode surface. The microdroplets, however, have been postulated to leave the cathode surface at angles up to about 30° above the cathode plane. The microdroplet emission is a result of extreme temperatures and forces that are present within emission craters.

The cathodic arc plasma deposition process was considered unsuitable for decorative applications until recently, due to the presence of microdroplets in the film.

Latest developments involving elimination of microdroplets in the CAPD process has provided a significant alternative to existing techniques for a wide range of decorative applications. The CAPD process offers additional flexibility in the following areas:
(i) The controls of deposition parameters is less stringent than magnetron sputtering or ion plating processes.
(ii) The deposition temperature for compound films can be adjusted to much lower temperatures thus allowing the ability to coat substrates such as zinc castings, brass and even plastics without melting the substrate.

In summary the CAPD process offers many advantages over the traditional sputtering process noted above. However, certain decorative applications requiring a thin film are best accomplished with a sputtering process. One such application is applying a thin coating of gold on jewelry.

This is due to the difficulty of eliminating microdroplets in gold, copper, and silver coatings in CAPD processes. Therefore, sputtering is the preferred method today for depositing a thin gold coating for decorative purposes.

Gold, however, is relatively soft. Under conditions of continuous use it develops a diffusely reflecting appearance and is simultaneously worn away, see US-A-4,591,418. A coating of titanium nitride (TiN) using the improved CAPD process creates excellent color matching to gold. Thus, it is possible to deposit titanium nitride on an inexpensive jewelry piece with the CAPD process and then deposit real gold over the titanium nitride. Jewelry with this two-layer coating offers the user a real gold plated piece plus a piece with the extremely wear resistant titanium nitride undercoat. Thus, if the real gold layer partially wears away, then the color-matched titanium nitride retains the look of real gold in the worn-away portion of the piece.

A difficulty in sequential layers of gold and TiN is that gold and TiN adhere very poorly to one another. Until the present invention, it was believed that only two basic methods were known to create multiple gold and TiN coatings. The first method is taught by the above US-A-4 591 418 which uses at least four interleafed layers of old and TiN. The second method is taught by US-A-4,415,421, which teaches simultaneous sputtering, by means of an electron beam, of three different layers. This process attempts to overcome the poor adhesion between gold and TiN by including an intermediary layer of TiN and gold between the bottom layer of TiN and the top layer of gold.

The present invention overcomes these difficulties and provides a convenient single system to enable the direct coating of gold over TiN without adhesion problems. The present invention includes an advanced CAPD process and a modern magnetron sputtering process in a single machine.

### SUMMARY OF THE INVENTION

It is, therefore, the object of the present invention to provide a machine capable of sequentially producing a coating using cathodic arc plasma deposition and magnetron sputtering.

Other aspects of this invention will appear from the following description and appended claims, reference being made to the accompanying drawings forming a part of this specification wherein like reference characters designate corresponding parts in the several views.

Certain terms used herein are defined below:
- Crossover setpoint:: A defined pressure in the vacuum chamber where rough pumping ceases and diffusion pump and cold trap pumping take over to reduce pressure to high vacuum.
- Hi-vac:: A short-hand expression for high vacuum.
- MilliTorr:: One thousandth of a Torr (or 0.133 Pa). See below.
- Substrate:: Refers to the objects being coated.
- Torr:: A unit of pressure; that pressure necessary to support a column of mercury one millimeter high at zero degrees Celsius and standard gravity (=133.3 Pa).
- Plasma:: A collection of charged particles containing equal numbers of positive ions and electrons and which is a good conductor of electricity and is affected by a magnetic field.)

The basic magnetron sputtering process is disclosed in Thin Film Processes, supra. Improvements are disclosed in US-A-4,162,954 and 4,180,450.

The basic CAPD process has evolved over the past twenty years. US-A-3,625,848 and 3,836,451 teach the origins of the basic process. US-A-4,430,184 and 4,724,058 disclose improvements to the basic CAPD process. A summary of the CAPD art is provided in "Technical Note: A Review of Cathodic Arc Plasma Deposition Processes And Their Applications" by H. Randhawa and P.C. Johnson (Surface and Coatings Technology, 31 (1987 pp. 303-318).

The present invention is a production CAPD and sputter coating system designed to deposit high performance metallurgical coatings onto a wide variety of substrates. It employs CAPD targets and sputter targets to deposit thin films of material onto substrates in a vacuum environment.

The sputter deposition process, using cathodes, is a relatively high voltage, low amperage, process adaptable to depositing virtually any material. The process bombards the target material with positive ions, dislodging mainly neutral target atoms by momentum transfer. The dislodged atoms condense into thin films on the substrates.

The CAPD process uses a relatively high amperage and low voltage to evaporate an electrically conductive target source material and condense it onto the substrates to form a coating.

The preferred embodiment of the present invention employs two 12.7 x 60.96 cm (5 x 24 inch) CAPD targets and two 8.89 x 93.5 cm (3.5 x 25 inch) sputter targets to generate materials to be deposited.

A substrate fixture bearing the substrates rotates in the chamber. Alternatively the substrate may be variably passed in front of the targets by means of planetary motion, oscillation, or reciprocation. A potentiometer or variable controller varies the speed of rotation according to the requirements of the deposition process.

DC bias power can be applied to the substrate fixture and substrates, during the deposition process, to enhance the movement of the target atoms toward the substrates and/or to affect the characteristics of the deposited film.

A diffusion pump, polycold trap (Meissner Trap), a cryogenic pump, or a turbomolecular pump create and maintain high vacuum in the chamber during the process. A mechanical pump evacuates the chamber to low vacuum (rough vacuum) and pumps (draws the exhaust away from) the diffusion pump or turbomolecular pump during high vacuum pumping.

A programmable logic controller (PLC) manages the process sequences. The system responds to the feedback of relevant processing parameters. Manual override is always available.

The major components of the present invention are:
1. the system main frame which supports and surrounds
   - the processing chamber,
   - the diffusion pump and polycold trap,
   - water and compressed air distribution panels,
   - mass flow controllers and valves for process gasses,
   - monitoring instruments, and
   - electrical terminal board.
2. the system control console containing the control instruments,
3. two CAPD target power supplies,
4. the mechanical pump,
5. the compressor for the polycold trap,
6. a power supply cabinet containing the power supplies for the targets and bias,
7. the power distribution cabinet and transformer,
8. the programmable logic controller (PLC)
9. computer,
10. the software for the computer, and
11. the software for the PLC.

### A Typical CAPD Process Cycle.

The operator loads the fixture with substrates and closes the front chamber door, sealing the chamber. The mechanical pump reduces pressure in the chamber to the crossover setpoint, typically set between 10 and 20 Pa (80 and 150 milliTorr).

The chamber roughing valve closes when the chamber reaches the crossover setpoint; the hi-vac valve opens a few seconds later. The closing of the chamber roughing valve isolates the mechanical pump from the chamber; the opening of the hi-vac exposes the chamber to the diffusion pump and polycold trap.

The pump-down cycle ends when the diffusion pump reduces pressure in the chamber to a preset level referred to as the base pressure and typically 2.6 x 10⁻³ Pa (2 x 10⁻⁵ Torr). The drive motor then begins to rotate the substrate fixture.

The reduction of pressure to the base pressure removes from the chamber most of the gas and water molecules which would otherwise interfere with the process.

Typically, nitrogen flows into the chamber, raising the pressure to 133 x10⁻³ Pa (1 x 10⁻³ Torr) or higher. The CAPD arc is then initiated. A high bias current initiates the cleaning cycle to clean the substrates with the sputtering action of ionized particles.

The high bias cycle ends and-the deposition cycle begins. Nitrogen gas back fills the chamber to operating pressure--a pressure between 665 and 2660 x 10⁻³ Pa (5 and 20 x 10⁻³ Torr).

Typically, nitrogen molecules combine with molecules of the CAPD target (i.e. titanium) during the reactive deposition process to form a coating of titanium nitride on the substrates; thus, the process consumes a portion of the nitrogen introduced into the chamber.

Nitrogen flows continuously into the chamber during the deposition process, requiring constant pumping by the high vacuum pump. The system balances the flow rate of the nitrogen with the pumping rate to keep pressure in the chamber at its operating pressure setpoint.

The system adjusts the flow rate of nitrogen with a mass flow controller, which compensates for the effect of pressure on the density of nitrogen and delivers standard volumes of gas regardless of pressure.

A negative voltage at the substrate accelerates the positively-charged ions of titanium en route from the targets. The negative voltage is called the bias voltage and is typically in the range of -50 to -500 volts (VDC).

The titanium targets are consumed during the deposition process and must be replaced periodically.

CAPD targets are connected to the negative output of the arc power supplies. Current flows from the arc targets through a plasma to an anode. Positively-ionised particles of titanium, stripped from the target by the current, flow toward the negatively-charged substrate, combining with nitrogen on the surface of the substrate to form the coating.

The PLC shuts off the nitrogen and power to the CAPD target sources at the conclusion of the deposition process and vents the chamber with nitrogen. When the chamber reaches atmospheric pressure, the PLC activates an audible signal.

### Sputtering.

Sputtering is a relatively high voltage, low amperage, deposition process, in contrast with a CAPD deposition process which employs relatively high amperages and low voltages.

Positive ions, generated in the glow discharge of the plasma, strike the target on the cathode and dislodge mainly neutral target atoms by momentum transfer.

The bombardment causes the target material to vaporize. Atoms dislodged from the targets condense into thin films on the substrate.

The targets in the preferred embodiment measure 89 x 635 mm (3.5 by 25 inches) and are cooled by water.

Magnetron cathodes trap the plasma in a process chamber close to the target material by crossing electrical and magnetic fields. The eroding action of the plasma on the targets yields a high sputtering rate per watt of power.

The preferred embodiment of the present invention uses water-cooled cathodes.

The operator may select from the following parameters from the PLC for a sputtering deposition cycle:
Sputter process time,
Cathode #1 power setpoint,
Cathode #2 power setpoint, and
Sputter gas pressure
The operator selects the gas from the system control panel. Argon is the preferred gas for the sputtering deposition process because of its mass.

The sputtering deposition cycle may also be automated. If the chamber is at base pressure, then the operator initiates the automated process by:
1. Switching to SPUTTER from CAPD at the deposition select panel.
2. Entering the sputter parameters at the PLC.
3. Pressing process START on the system control panel.
4. Adding bias power if desired.

The completion of the above noted CAPD and sputter process in the present invention will produce brilliant gold plated jewelry or a variety of other coatings on any substrate.
- Fig. 1: Shows a schematic of a basic Planar Magnetron Sputtering System.
- Fig. 2: Shows a schematic of a basic Cathodic Arc Plasma Deposition (CAPD) System.
- Fig. 3: Shows a schematic of the major components of the Dual Coating System of the invention.
- Fig. 4: Shows a right side elevational view of the Dual Coating System mainframe having partial cutaways.
- Fig. 5: Shows a left side elevational view of the Dual Coating System mainframe having partial cutaways.
- Fig. 6: Shows the interior view of the right chamber door of the Dual Coating System mainframe.
- Fig. 7: Shows the interior view of the left chamber door of the Dual Coating System mainframe.
- Fig. 8: Shows a front elevational view of the Dual Coating System mainframe with the front chamber door and front enclosure panels cutaway.
- Fig. 9: Shows a top perspective view of the back of the Dual Coating System mainframe having cutaways of all enclosure panels and the upper support frame.
- Fig. 10: Shows a top view of the mainframe of the Dual Coating System having all pumps removed.
- Fig. 11: Shows a front elevational view of the left vacuum chamber door of the Dual Coating System mainframe having the enclosure panels removed.
- Fig. 12: Shows a front elevational view of the master control panel.
- Fig. 13: Shows a front perspective view of the vacuum chamber portion of the Dual Coating System mainframe. The front and right side doors are removed.
- Fig. 14: Shows a front perspective view of the vacuum chamber and substrate fixturing.
- Fig. 15: Shows a top view cross section of the vacuum chamber showing all major process cathodes.
- Fig. 16: Shows a longitudinal sectional view of the internally mounted sputtering cathode taken along line A-A of Fig. 15 which is coincident with the line B-B of Fig. 13.
- Fig. 17: Shows a longitudinal sectional view of the internally mounted CAPD cathode taken along line C-C of Fig. 15 which is coincident with line D-D of Fig. 13.
- Fig. 18: Shows a front perspective view of a substrate clamp assembly for rings.
- Fig. 19: Shows a software flow chart of the Program Logic Controller (PLC) logic.

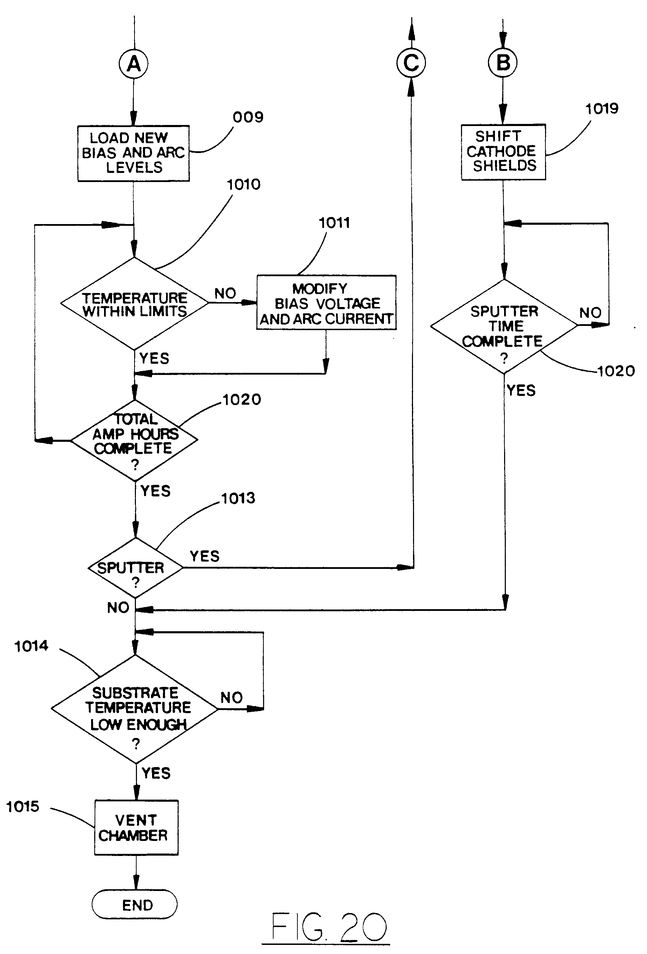

- Fig. 20: Shows a continuation of Fig. 19.

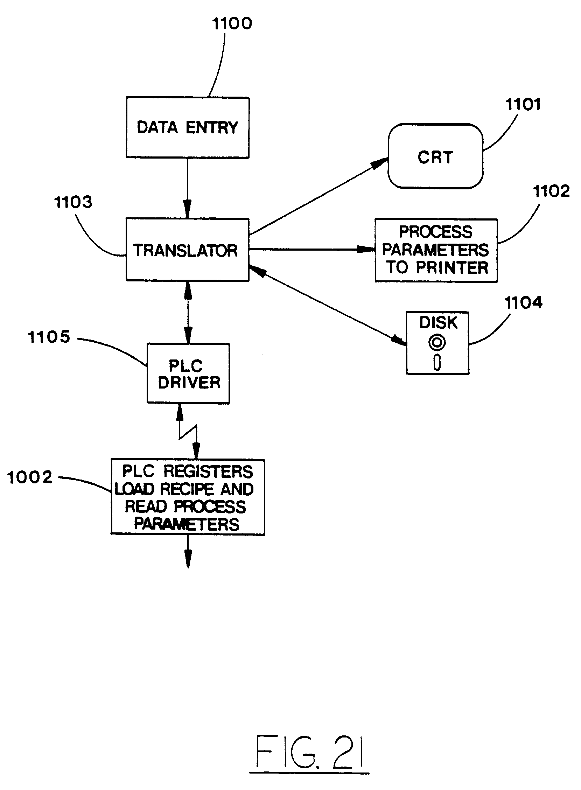

- Fig. 21: Shows a software flow chart of the Personal computer (PC) logic.
- Fig. 22: Shows a table of relative lusters and colors for various films produced by the present invention.

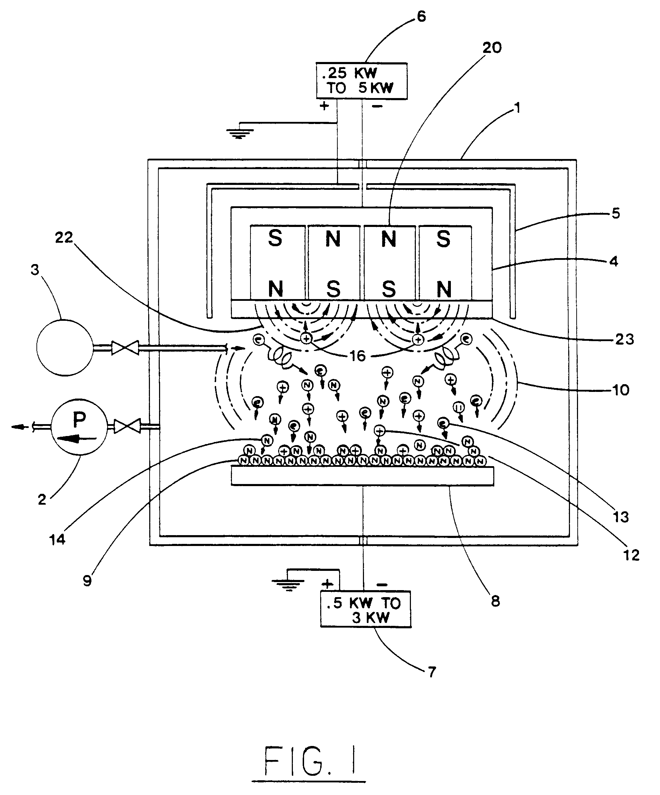

Referring first to Fig. 1, a basic magnetron sputtering system comprises a vacuum chamber 1, a pump system 2, and a sputtering gas source 3. The vacuum chamber 1 houses a target/cathode 4 and an anode 5. Sputtering power supply 6 biases the target/cathode 4 negative and the anode 5 positive. The sputtering process uses a high voltage and low current power supply. A substrate 8 is a workpiece to be coated with a thin film 9. Substrate 8 is biased negative by substrate power supply 7.

During the sputtering process the sputtering gas source 3 supplies non-reactant gas, argon. The pump system 2 maintains a vacuum in the range of a few tenths of a Pascal (milliTorr)to a few Pascals (tens of milliTorr). The sputtering power supply 6 powers up causing a glow discharge 10 between the anode 5 and the target/cathode 4.

The glow discharge 10 causes positive ions of nonreactive gas to bombard the target/cathode 4 (see arrow 16). Momentum transfer causes neutral target atoms N, electrons e, and positive ions +, to dislodge from the target/cathode 4. Neutral target atoms N condense into a thin film 9 on substrate 8. (see arrow 14). Additionally, a small percentage of positive ions + also condenses on the substrate. Positive ions and electrons also bombard the substrate 8 while thin film 9 is growing ( see the arrows 12 and 13).

A magnet 20 is located behind the target/cathode 4. The magnet 20 creates a magnetic field around the target/cathode 4 as shown by lines 22. The magnetic field 22 is typically in the order of a few hundred gauss. Magnetic field 22 traps a substantial number of electrons against the target/cathode surface 23. This effect of trapping the electrons serves two basic purposes. First, fewer electrons reach the substrate 8, thereby maintaining the substrate 8 at a cooler temperature. Second the constant motion of the electrons at target/cathode surface 23 enhances the sputtering yield, the emission rate of neutral particles N, from the target/cathode surface 23. This enhanced sputtering yield allows a faster growing of thin film 9 on the substrate 8. Thus a manufacturing efficiency is realized by reducing the time necessary to coat thin film 9 on substrate 8.

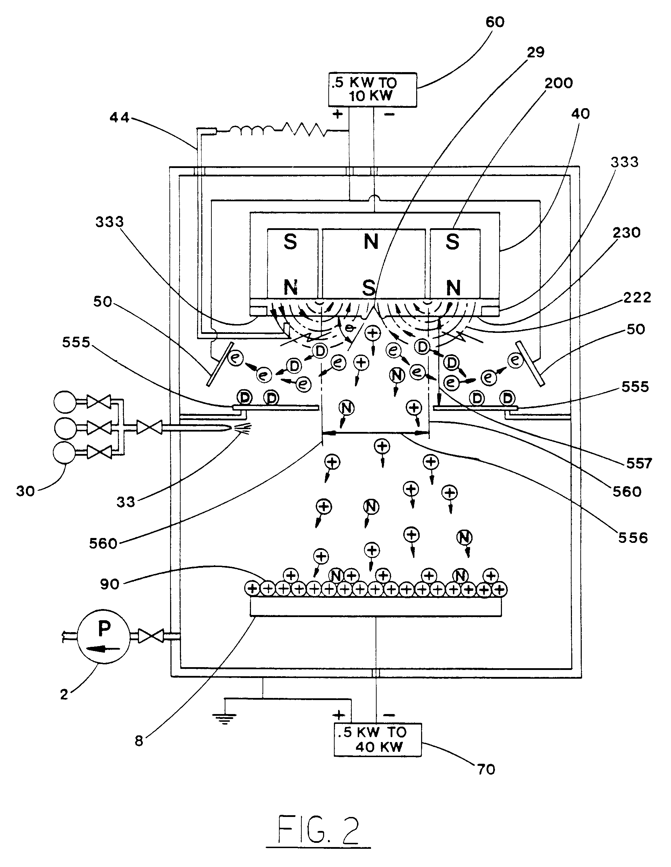

Referring next to Fig. 2 a basic cathodic arc plasma deposition (CAPD) system comprises a vacuum chamber 1, a pump 2, and an optional gas source 30. The vacuum chamber 1 houses a target/cathode 40 and an anode 50. CAPD power supply 60 biases the target/cathode 40 negative and the anode 50 positive. The CAPD process uses a low voltage and high current power supply. A substrate 8 is a workpiece to be coated with a thin film 90. Substrate 8 is biased negative with respect to ground by substrate power supply 70.

During the CAPD process at least one gas 33 is introduced into the vacuum chamber 1 by gas source 30. The pump system 2 maintains a vacuum in the range of 13 x 10⁻³ Pa (1 x 10⁻⁴ Torr) to 133 x 10⁻³ Pa (1 x 10⁻³ Torr). The substrate power supply 70 biases the substrate 8 to a high voltage in the range of 200 to 1000 volts DC. RF voltages may be used for non-conducting materials.

Next the CAPD power supply 60 applies voltage to the target/cathode 40 and the anode 50. Next the arc starter 44 ignites an arc 100 between the target/cathode 40 and the anode 50. An arc spot 29 forms on the target/cathode surface 230. The arc spot 29 moves at a speed of the order of a hundred meters per second on the target/cathode surface 230. Multiple arc spots 29 are created by using higher arc currents. The arc spot 29 moves under the control of the magnet 200 in a predetermined pattern. The magnet 200 produces a magnetic field 220 in the range of 10-50 gauss. The arc spot(s) 29 is confined to the target/cathode surface 230 by means of an insulating border 333.

The arc spot(s) vaporizes the target/cathode 40 thus forming a stream of positive ions +, electrons e, droplets D, and neutral atoms n. The droplets D are removed from the stream by means of deposition shields 555. Droplet removal shields 555 are suitably placed in front and to the sides of target/cathode 40.

The electrons flow to the anode 50 of the arc circuit. The positive ions bombard the substrate 8 thereby cleaning and heating the substrate 8.

After adequate cleaning, additional gas or gases 33 is added into the vacuum chamber 1 to establish pressures in the range of 133 x 10⁻³ Pa (1 x 10⁻³ Torr) to 6.6 Pa (5 x 10⁻² Torr).

Next the substrate 8 is biased by substrate power supply 70 to a lower voltage in the range of 50 - 200 volts DC or RF.

Maintaining the arc 100 causes the thin film 90 to grow on the substrate 8 by the deposition of positive ions and a small percentage of neutral atoms. The thin film 90 thickness and the rate of deposition are controlled by varying the arc current, vacuum chamber 1 pressure, the substrate 8 bias voltage, the substrate temperature and the process time.

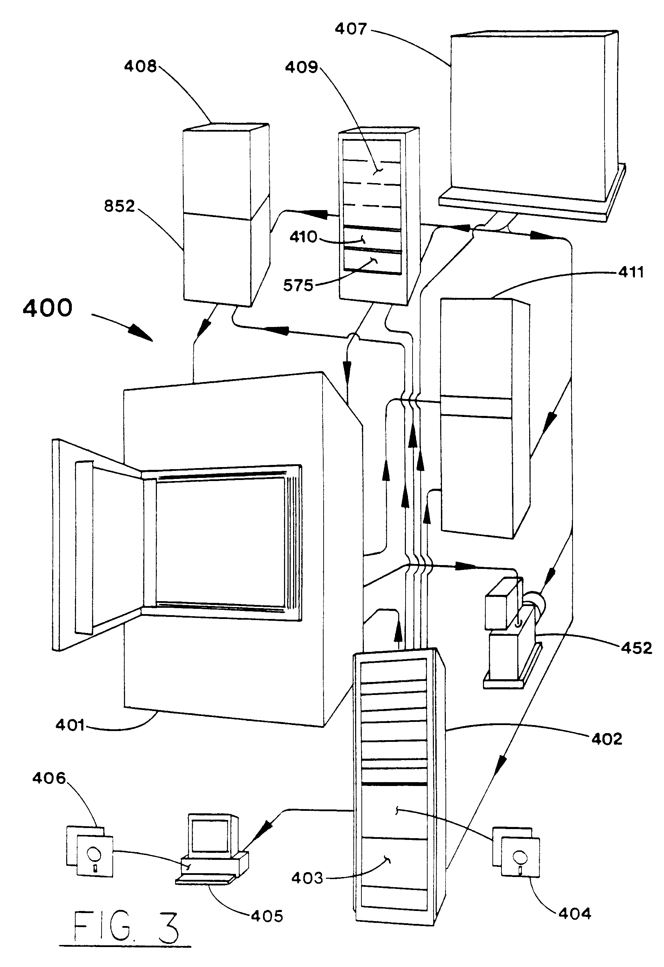

Referring next to Fig. 3 the dual coating system 400 comprises a mainframe 401, a master control panel 402, a programmable logic controller (PLC) 403, PLC software 404, a personal computer (PC) 405, PC software 406, a power distribution panel 407, arc source power supplies 408, 852, a substrate bias power supply 409, sputtering power supplies 410, 575, a control unit for the cryogenic trap 411, and a mechanical pump 452.

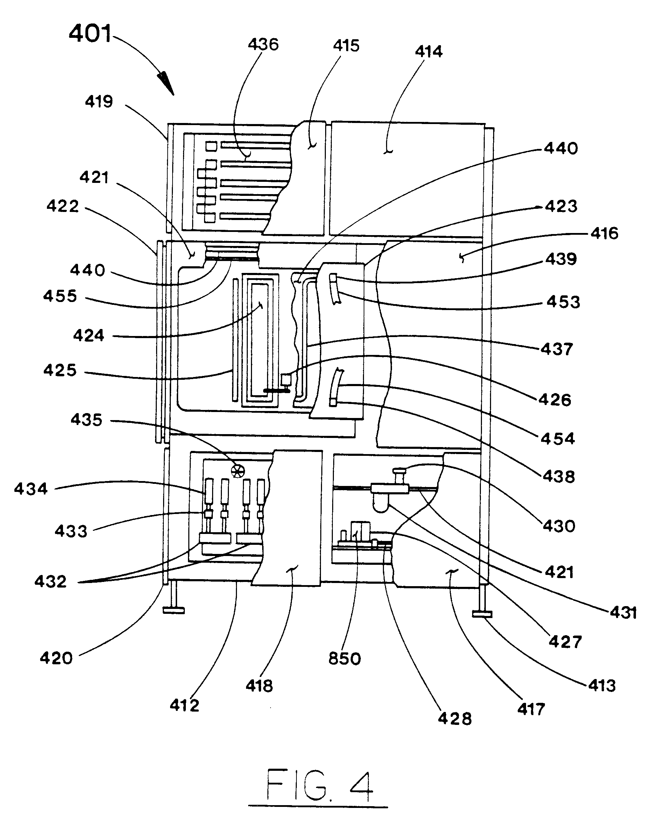

Referring next to Fig. 4 the right side of the dual coating mainframe 401 has a support skeleton 412, leveling feed 413, enclosure panels 414, 415, 416, 417, 418, 419, and 420, vacuum chamber 421, front chamber door 422, right side chamber door 423, CAPD cathode 424, CAPD anode 425, arc starter 426, process gas mass flow control valves 427, a flow sensor 850, process gas supply pipe 428, a compressed air supply pipe 429, a compressed air pressure regulator 430, a compressed air filter 431, a cooling water supply manifold 432, a cooling water flow control valve 434, a cooling water safety switch 435, and an electrical terminal board 436.

Multiple chamber doors 422, 423 serve to offer ease of access to internal components for maintenance as well as flexibility in loading and unloading workpieces. Compressed air components 429, 430, and 431 operate the pneumatic valves in the dual coating system 400. Cooling water components 432 and 434 distribute and control cooling water to the internal chamber pipes 437. Inlet port 438 and outlet port 439, in combination with internal chamber pipes 437 and cooling water supply manifold 432, form an internal water-cooled surface 400 around vacuum chamber 421. Cooling water safety switch 435 working in conjunction with master control panel 402 shuts off all power if cooling water flow drops below a predetermined setpoint. The electrical terminal board 436 serves as the common termination point for all wiring to the mainframe 401.

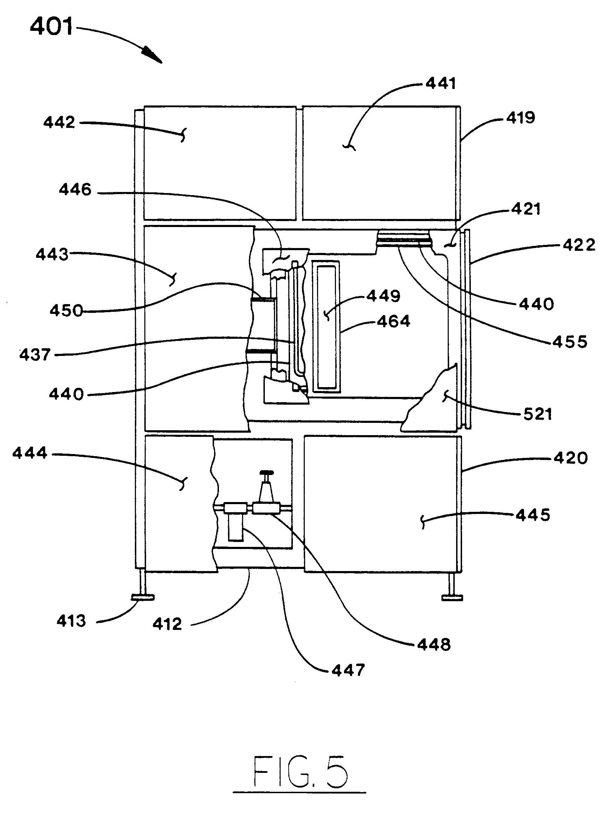

Referring next to Fig. 5 mainframe 401 has enclosure panels 441, 442, 443, 444, 445, 419 and 420, left side chamber door 446, cooling water filter 447, cooling water regulator 448, sputtering cathode 449, sputtering anode 464, and high vacuum pumping port 450.

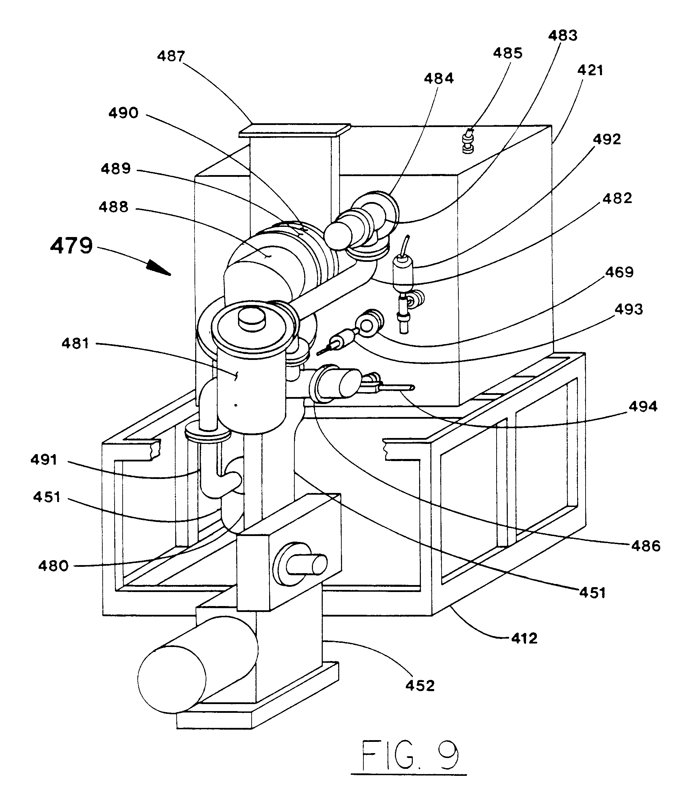

Mainframe 401 has three chamber doors 446, 422 and 423 for process and maintenance flexibility. High vacuum pumping port 450 connects to the cryogenic trap 489 and the diffusion pump 451 (Fig. 9).

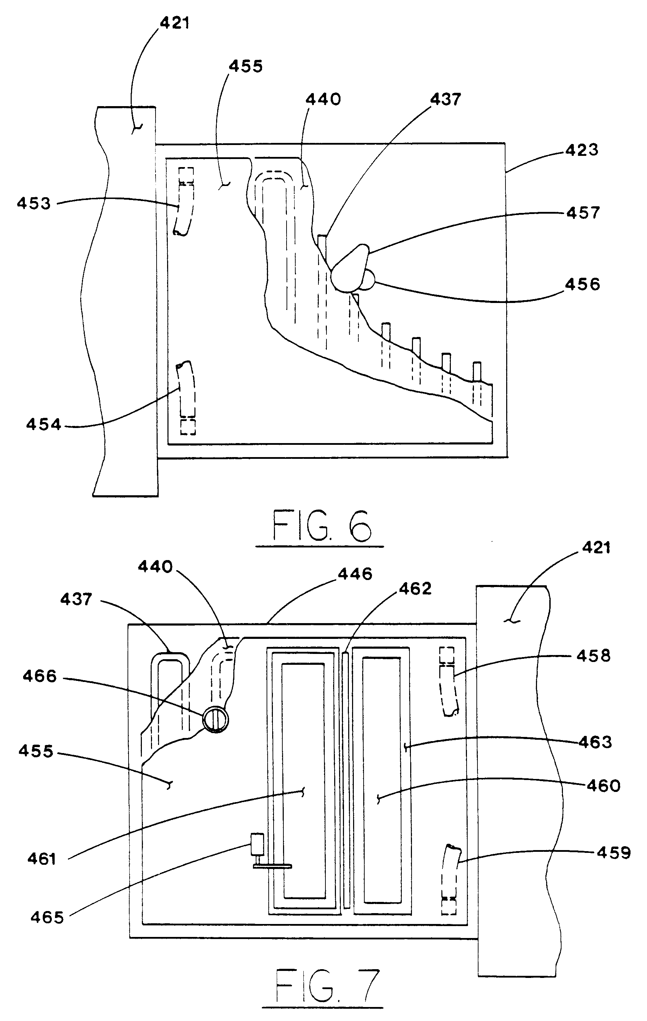

Referring next to Fig. 6 the right chamber door 423 contains the same internal chamber pipes 437 as the rest of the chamber. Flexible hoses 453 and 454 carry cooling water into the right chamber door 423.

A deposition shield 455 overlays the water cooled surface 440. Deposition shield 455 is generally made of stainless steel and serves to protect the underlying surfaces from the deposition processes.

A viewport 456 allows users to peer into the vacuum chamber 421. A viewport shutter 457 is manually placed in front of the viewport 456 to protect the viewport 457 from the deposition process.

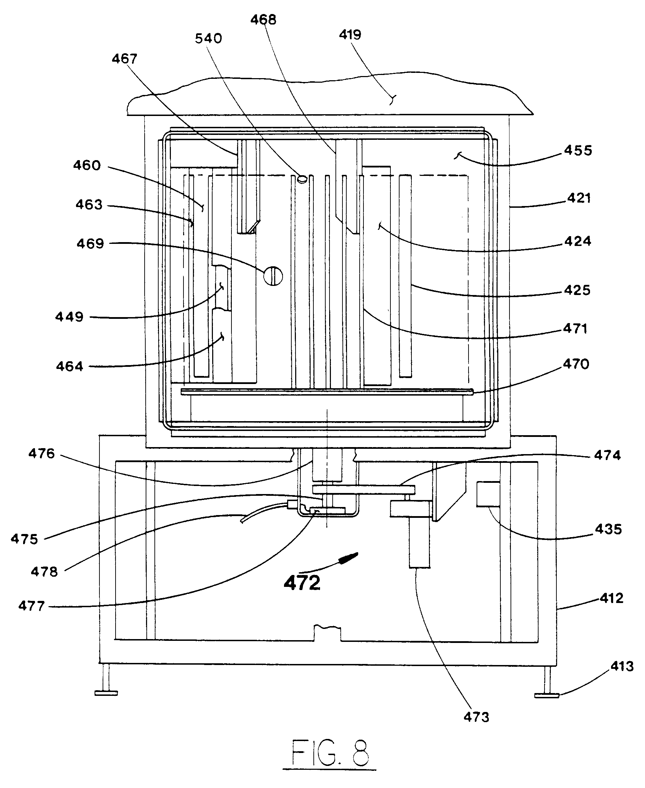

Referring next to Fig. 7 the left chamber door 446 has internal chamber pipes 437 and flexible hoses 458 and 459, and deposition shield 455. A door mounted sputtering cathode 460 is powered during the sputtering process. A door mounted CAPD cathode 461 is powered during the CAPD process. Sputtering anode 463 and CAPD anode 462 are shown. Arc starter 465 starts the vacuum arc during the CAPD process.

The substrate temperature monitor 466 is an infrared sensor.

Referring next to Figure 8 vacuum chamber 421 houses internally mounted CAPD cathode 424 and the corresponding CAPD anode 425, the CAPD cathode mounting bracket 468 internally mounted sputtering cathode 449, and the corresponding sputtering anode 464, the sputtering cathode mounting bracket 467, door mounted sputtering cathode 460 and the corresponding sputtering anode 463, a second substrate temperature infrared sensor 469, the substrate turntable 470, and the substrate mounting fixture 471.

The substrate turntable 470 rotates under the control of the master control panel 402 during either the sputtering or CAPD process. The substrate mounting fixture 471 is custom designed for various substrates.

A substrate turntable drive assembly 472 comprises a drive motor 473, a drive belt 474, a turntable drive shaft 475, a rotary vacuum seal 476, substrate bias voltage connection 477, and the substrate bias voltage cable 478.

Drive motor 473 is a variable speed unit enabling precise control of the substrate turntable 470 speed. The rotary vacuum seal 476 maintains the integrity of the vacuum chamber 421 during processes. The bias voltage cable 478 connects to the substrate bias power supply 409 (Fig. 3).

Referring next to Figure 9 the dual coating system pumping assembly 479 is shown. The pumping assembly 479 starts with the mechanical pump 452. Mechanical pump 452 pumps the vacuum chamber to a crossover pressure ranging from 8 to 12 Pa (60 to 90 mTorr). Mechanical pump 452 connects to the vacuum chamber 421 through the inlet pipe 480, the inlet filter 481, the connector pipe 482, the roughing valve 483 and the chamber roughing port 484.

Thermocouple gauge 485 measures vacuum chamber 421 pressure and transmits this pressure to the master control panel 402 (Fig. 3). When the vacuum chamber 421 pressure reaches the predetermined crossover pressure, the master control panel 402 closes the roughing valve 483 and opens the foreline valve 485 and opens the high vacuum valve 487. These valve actions connect the mechanical pump 452 in series with the diffusion pump 451. These serial pumps 451 and 452 are connected to the vacuum chamber 421 through the high vacuum piping 488 and the cryogenic trap 489 and the throttle valve 490 and the high vacuum valve 487 and the chamber high vacuum port 450 (Fig. 5).

After the above noted crossover procedures are accomplished, the mechanical pump 452 maintains the diffusion pump foreline 491 at low pressure while the diffusion pump 451 further reduces the vacuum chamber 421 pressure to a system base pressure ranging from 2.66 x 10⁻³ Pa (2 x 10⁻⁵) to 66.5 µPa (5 x 10⁻⁷ Torr). Simultaneously the cryogenic trap 489 condenses water vapor and other condensable gases, thereby increasing the efficiency of the diffusion pump 451.

Process pressures are controlled by the master control panel 402 operating the throttle valve 490 in response to signals from the capacitance manometer sensor 492. The foregoing control loop is known as a downstream pressure control system. The infrared temperature sensor 493 views the substrates 540 through viewport 469, (see Fig. 8) thereby providing the temperature control signal to the master control panel 402.

When processing is complete the vacuum chamber 421 is raised back to atmospheric pressure by means of vent valve 494.

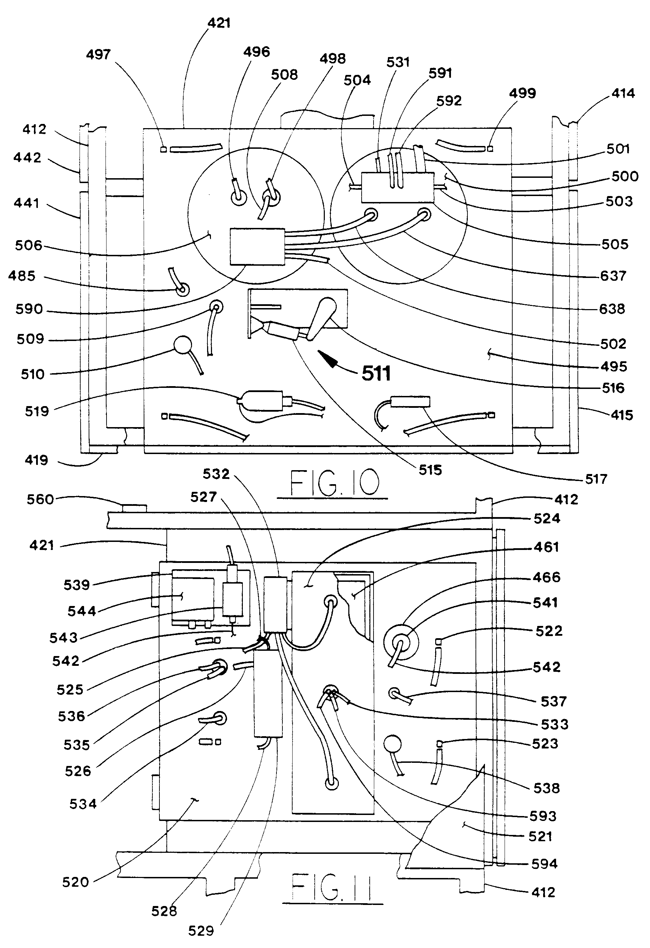

Referring next to Fig. 10 the top of the vacuum chamber 495 is seen supported by the support skeleton 412. Water inlet 497 provides cooling water to the internal chamber pipes 437 as supplied by the cooling water supply manifold 432, see Fig. 4. Water outlet 499 is then returned to the cooling water supply manifold 432.

CAPD cathode utility plate 500 contains the electrical power leads 501 to the anode and 502 to the cathode of the CAPD cathode 424 and CAPD anode 425 as seen in Fig. 4. Anode cooling water inlet 503 feeds CAPD anode 425, and the anode cooling water outlet 504 returns to the cooling water supply manifold 432. Insulating enclosure 505 protects the CAPD cathode utility plate 500 from anode electricity. Cooling water inlet 591 supplies cooling water from the cooling water supply manifold 432 (Fig. 4) to the CAPD cathode 424. An outlet 592 returns the cooling water to the cooling water supply manifold 432.

Sputtering cathode utility plate 506 contains the electrical power leads 507 to the anode and 508 to the cathode of the sputtering anode 464 and sputtering cathode 449 as shown in Fig. 5. Insulating enclosure 590 insulates the sputtering cathode utility plate 506 from electricity. Cooling water inlet 496 provides cooling water to the sputtering cathode 449 from the cooling water supply manifold 432. Cooling water return provides the return to cooling water supply manifold 432.

Electric power for the arc starter 426 is supplied by leads 509 and 510. Electric power for the CAPD cathode electromagnet 530 is supplied by cable 531.

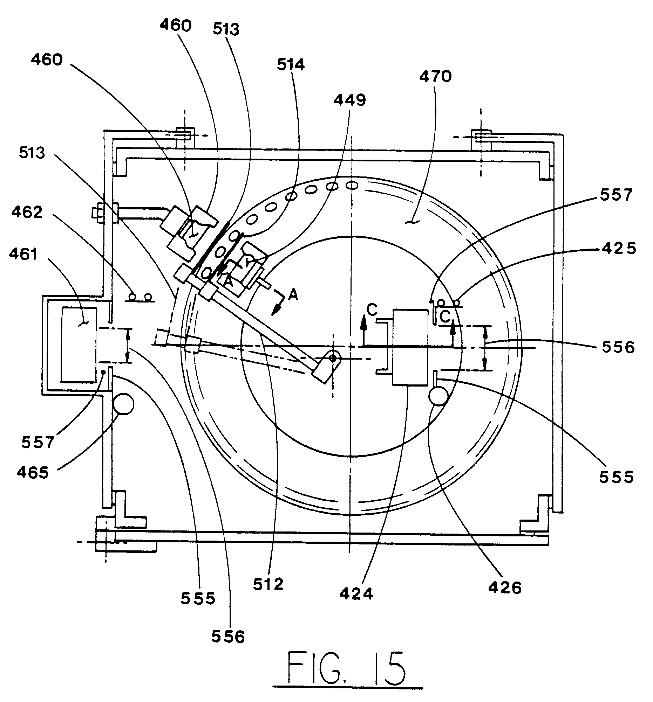

Shield armature 512 (see Fig. 15) is activated by activating assembly 511. Activating assembly 511 consists of a pneumatic cylinder 515 and crank arm 516.

Vacuum chamber 421 pressure is sensed and transmitted by pirani gauge 517, thermocouple gauge 518 and ion gauge 519. Pirani gauge 517 measures pressures ranging from atmospheric to 0.13 Pa (1 mTorr). Thermocouple gauge 485 measures pressures ranging from atmospheric to 0.13 Pa (1 mTorr). Ion gauge 519 measures pressures ranging from 0.13 Pa - 13 µPa (1 mTorr - 0.0001 mTorr). Thermocouple gauge 518 triggers the master control panel 401 for switching the ion gauge 519 on.

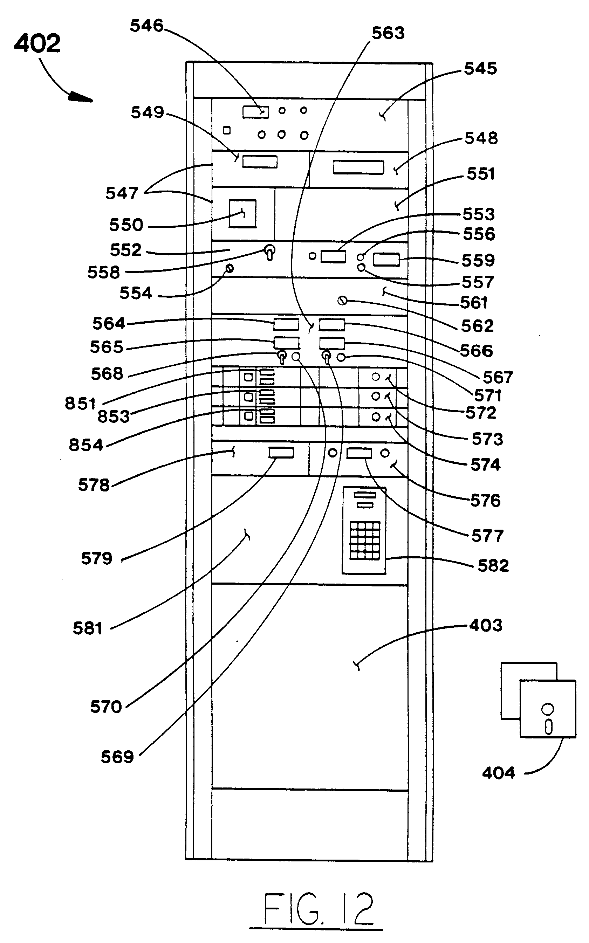

Referring next to Fig. 11 the vacuum chamber 421 is seen supported by the support skeleton 412. The left-hand vacuum chamber door 520 opens for loading and maintenance. An enclosure panel 521 is cut away. Water inlet 522 and water outlet 523 feed the internal chamber pipes 437 from the cooling water supply manifold 432. Water inlet 593 supplies cooling water from the cooling water supply manifold 432 to the door mounted CAPD cathode 461. Outlet 594 returns the cooling water through the cooling water supply manifold 432.

The door mounted CAPD cathode 461 is mounted inside CAPD door enclosure 524. Power to the door mounted CAPD cathode is supplied by lead 525. Power to the CAPD anode 462 is supplied by lead 526. Cooling water inlet 527 supplies cooling water from the cooling water supply manifold 432 to the door mounted CAPD anode 462 as shown in Fig. 7. Cooling water return 528 supplies the return to cooling water supply manifold 432.

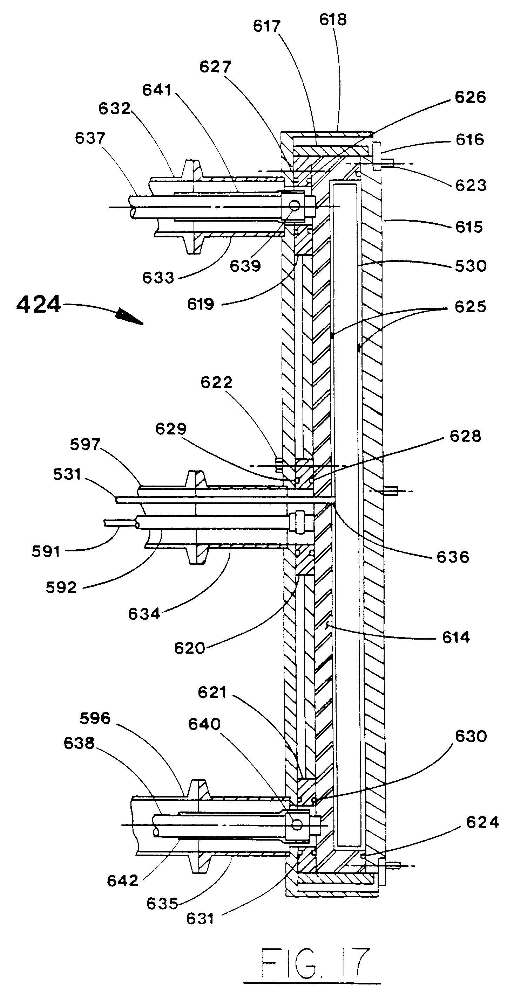

Electrical insulating enclosure 529 electrically isolates the door mounted CAPD anode 462. Electrical insulating enclosure 532 electrically isolates the door mounted CAPD cathode 461. CAPD electromagnet 530 (Fig. 17) is powered by cable 533. Water inlet 534 supplies cooling water from the cooling water supply manifold 432 to the door mounted sputtering cathode 460 (see Fig. 7). The water returns via water outlet 535. Lead 536 powers the door mounted sputtering cathode 461. Leads 537 and 538 power the arc starter 465 (Fig. 7)

An infrared sensor 539 measures the substrate 540 temperature as shown in Fig. 8. The infrared sensor 539 consists of a lens assembly 541, a fiber optic cable 542, and the infrared sensing unit 543. Infrared sensing unit 543 measures and transmits the substrate 540 temperature to the master control panel 402. High intensity light source 544 calibrates lens assembly 541. Enclosure safety switches 560 prevent operation if an enclosure panel is ajar.

Referring next to Fig. 12 the master control panel 402 consists of a substrate temperature transmitter 545 which indicates temperatures from the infrared sensors 493 and 543 by means of gauge 546.

Substrate temperature transmitter 545 switches between infrared sensing units 493 and 543 and subsequently transmits the substrate temperatures to the programmable logic controller (PLC) 403.

The vacuum chamber pressure monitoring panel 547 consists of a thermocouple gauge indicator 548 which senses inputs from the thermocouple sensor 518 (Fig. 10). The ion gauge indicator 549 senses inputs from the ion tube 519 (Fig. 10). The pirani gauge indicator 550 senses inputs from the pirani gauge sensor 517. Additionally the pirani gauge indicator 550 transmits signals to the valve control panel 551 which in turn controls the roughing valve 483, the high vacuum valve 487, and the vent valve 494. The valve control panel 551 also controls the diffusion pump foreline valve 486 and the throttle valve 490 (Fig. 9).

The system control panel 552 consists of a drive motor 473 speed indicator/controller 553. Additionally the system control panel 552 provides a manual/automatic mode of operation by means of selector switch 554. Manual control switch 558 offers manual control of the process gas mass flow control valve 427 (Fig. 4). To initiate either the CAPD or sputtering process master start switch 556 must be switched "on". Process termination may be manually accomplished by switching the process stop switch 557 "off". A process status board 559 indicates the statuses of vacuum chamber 421 pressure range, cooling water safety switch 435 (Fig. 4), enclosure safety switch 560 (Fig. 11) status, drive motor 473 overtorque indicator (Fig. 8), and the overall process enable status indicator.

The process selection panel 561 provides selection of either the CAPD or sputtering process by means of selector switch 562.

The arc control panel 563 displays the respective CAPD voltages and amperages by means of indicators 564, 565, 566, and 567. The operator may manually select whether to use one or both of the CAPD cathodes 424/461 by means of selector switches 568 and 569. The CAPD arc power may be manually controlled by potentiometers 570 and 571.

Varying substrate 540 surface areas require varying bias power requirements. Substrate bias power control module 572 controls the bias power supply 409 and indicates bias voltage by means of indicator 851. The internal sputtering cathode controls the internal sputtering power supply 410. The door mounted sputtering cathode power control module 574 controls the door mounted sputtering power supply 575 (Fig. 3). Power indicators 853 and 854 integral to the sputtering cathode control modules 573 and 574 indicate the electrical power levels of the respective sputtering cathodes.

The capacitance manometer sensor 492 (Fig. 9) transmits a signal to the capacitance manometer controller 576. The vacuum chamber 421 pressure is indicated by the indicator 577 integral to the capacitance manometer controller 576. Additionally the capacitance manometer controller 576 provides an input signal to the process gas controller 578.

The process gas controller 578 displays the process gas flow by means of indicator 579. Flow sensor 850 (Fig. 4) supplies input to the indicator 579. The process gas controller 578 modulates process gas mass flow control valve 427 in response to signals from the capacitance manometer controller 576, thereby controlling vacuum chamber 421 pressure. The foregoing control loop constitutes an upstream pressure control system.

Support panel 581 houses the PLC input module 582. PLC input module 582 is used to key enter variable data into the PLC 403. The PLC 403 contains PLC software 404 which automatically can control all the CAPD and sputtering process functions for the Dual Coating System 400.

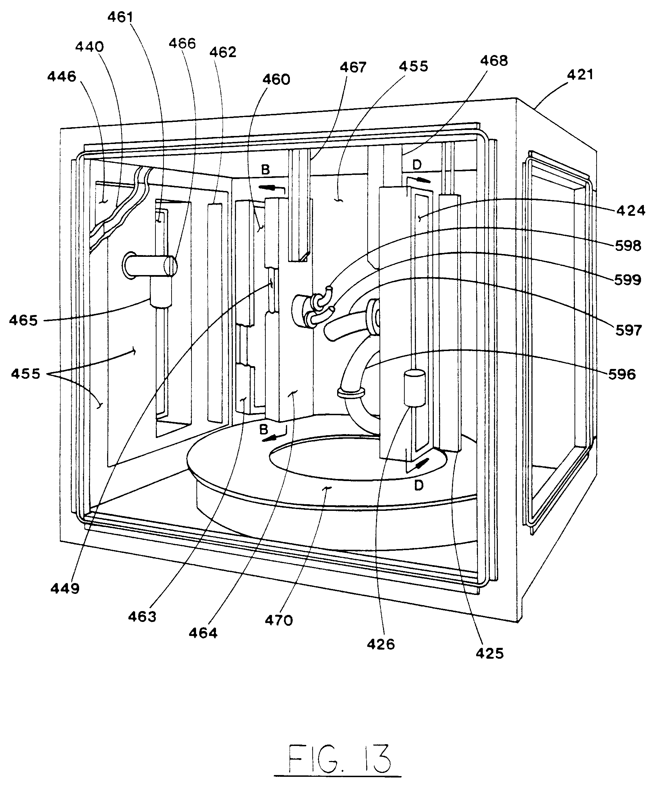

Figures 13, 14 and 15 show the spatial relationships of the main operating components of the dual coating system 400. Fig. 13 shows the substrate turntable 470. The internally mounted CAPD cathode 424 is supported above and in close proximity to the substrate turntable 470 by means of the CAPD cathode mounting bracket 468. The corresponding CAPD anode 425 and arc starter 426 are commonly mounted to the same CAPD cathode mounting bracket 468. Utility cable 596 and 597 house cooling water pipes and electrical conductors serving the internally mounted CAPD cathode 424.

The internally mounted sputtering cathode 449 and corresponding anode 464 are mounted on the sputtering cathode mounting bracket 467. Corresponding utility cables 598 and 599 house cooling water pipes and electrical conductors serving the internally mounted sputtering cathode 449.

The door mounted sputtering cathode 460 and its corresponding anode 463 faces the internally mounted sputtering cathode 449 such that simultaneous sputtering coating on both sides of the substrate 540 can be accomplished.

The door mounted CAPD cathode 461 coats the outside of the substrate 540 while the internally mounted CAPD cathode coats the inside of the substrate 540. The corresponding CAPD arc starter 465 and anode 462 are mounted on the same left chamber door 446. The substrate temperature monitor 466 protrudes beyond the deposition shield 455.

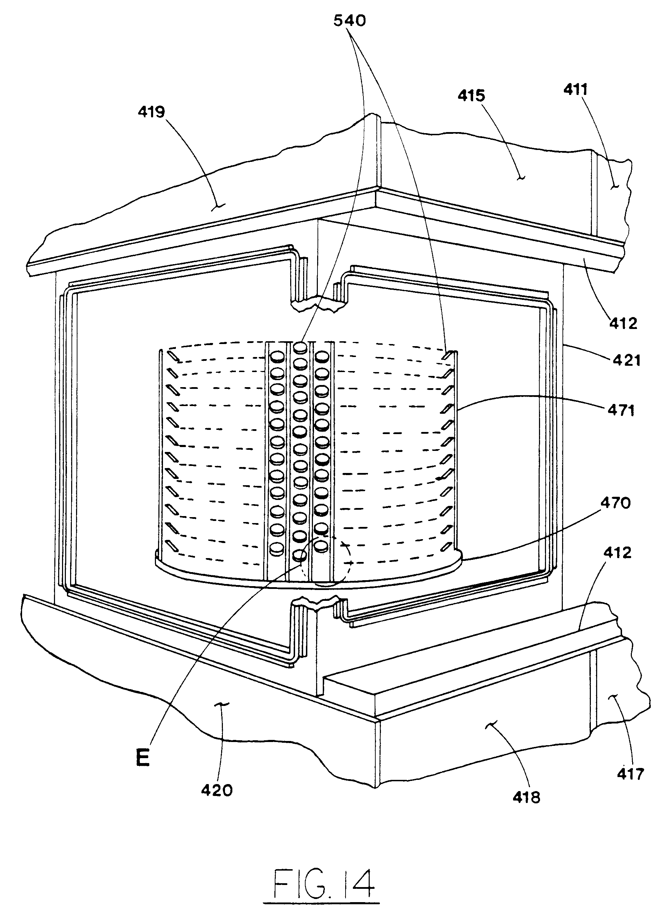

Fig. 14 shows a typical mounting arrangement for small substrates such as rings. The substrate turntable 470 is in electrical contact with the substrate mounting fixture 471 which in turn is in electrical contact with the substrate 540.

Fig. 15 shows in dotted lines how the shield armature 512 moves the sputtering cathode shields 513 and 514 away from the sputtering cathodes 449 and 460 during the sputter coating. The shield armature 512 shown in solid lines moves the sputtering cathode shields 513 and 514 in front of the sputtering cathodes 449 and 460 to protect them from being coated during the CAPD process.

The droplet removal shields 555 (see Fig. 2) serve to remove all droplets D from the stream of positive ions, electrons, and neutral atoms vaporizing from the door mounted CAPD cathode 461 and the internally mounted CAPD cathode 424.

Referring to Figure 2 the droplets D comprise molten metal particles which if allowed to land on the substrate 8 results in rough and low luster films. This is unacceptable for decorative applications. It has been experimentally determined that droplets D are emitted at angles of 30 degrees or less when the CAPD target 615 (Fig. 17) has a minimal area of 6450 mm² (ten square inches). The distance 557 of the droplet removal shields 555 and the opening 556 are selected to prohibit the droplets D from reaching the substrate 8 (Fig. 2).

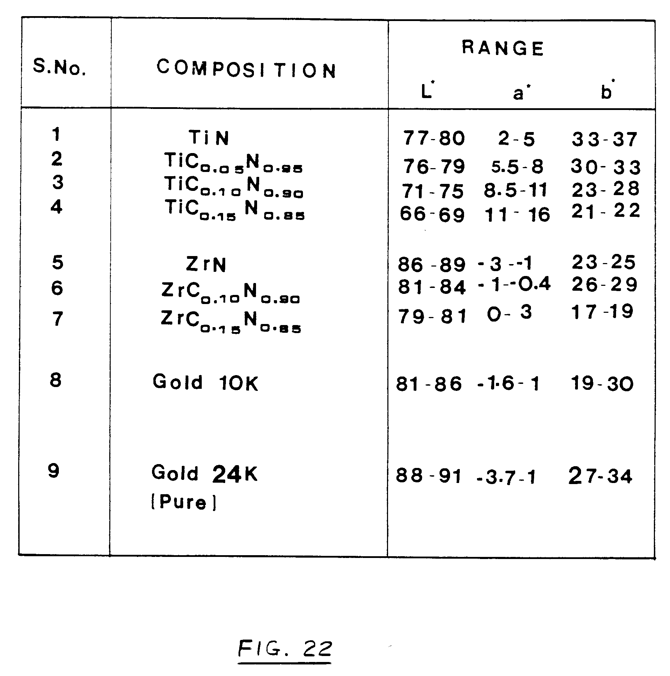

The main purpose of the present invention is to provide a film having a high luster and a consistent color controllable to match various gold colors. Fig. 22 shows a sampling of films produced by the present invention. Sequence numbers 8 and 9 list the 10 carat and 24 carat gold characteristics used herein as a standard. L* denotes the luster or brilliance of the film as measured per the CIE Lab color coordinates. a* denotes a range of red to green contents in the film. Positive a* values denote red contents, and negative a* values denotes green contents in the film. b* denotes a range of yellow to blue contents in the film. The positive b* values indicate a high yellow content in the film. Negative values would indicate a blue content in the film.

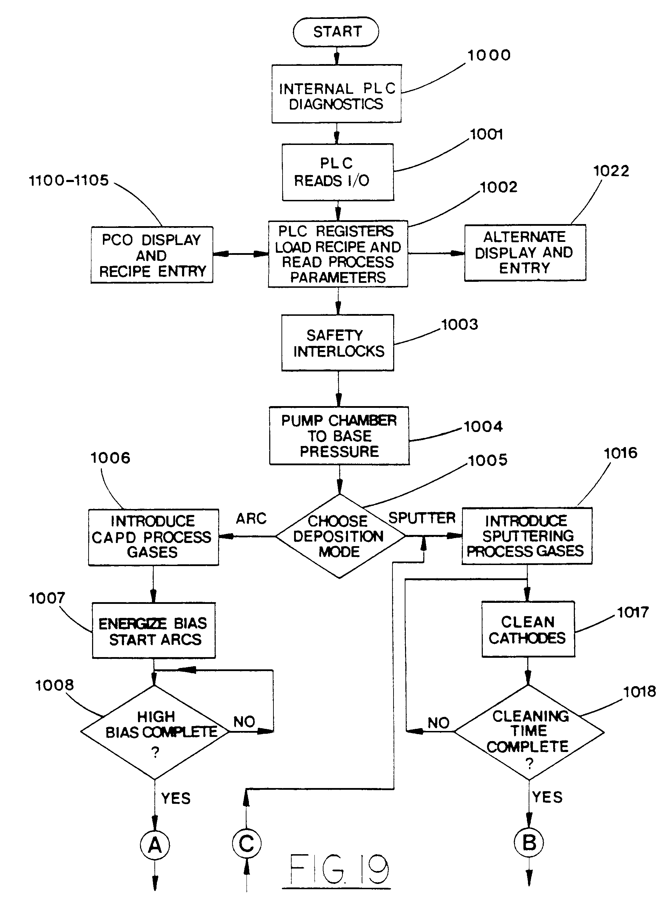

Sequence numbers 1 through 7 show specific film characteristics produced by the CAPD process used in the dual coating system 400. Referring to Fig. 19, block 1006 varies the ratios of two process gases (Fig. 2, 33) which comprise acetylene as a source of carbon, and nitrogen. Suitably adjusting the ratios of carbon and nitrogen in the titanium- and zirconium-based films results in the excellent matching of luster and color film characteristics relative to gold as shown in Fig. 22. Thus in the typical dual coating system 400 operation a CAPD film is produced from the above noted Fig. 22 sequence numbers 1 through 7. Next a gold film may be applied using the sputtering process as shown in Fig. 1.

The preferred embodiment produces in sequence the above noted two films during a single vacuum cycle (Fig. 19 block 1004). The adhesion of a second film, consisting of gold on top of a CAPD deposited film taken from the selection in Fig. 22 sequence numbers 1 through 7, is commercially acceptable. A commercially acceptable adhesion is determined by using a 'Scotch (trademark) tape pull test. This test results in no gold removal.

The ultimate purpose of the dual coating system 400 is to provide a single system which enables the direct coating of gold over TiN or ZrN without adhesion problems. In practice the gold wears off the substrate 8 (Fig. 1), thus exposing the TiN or ZrN film underneath. It is critical that the substrate 8 maintains the same appearance as the gold film wears off. Thus the relative values in Fig. 22 sequence numbers 1 through 7 in relation to sequence numbers 8 and 9 are critical.

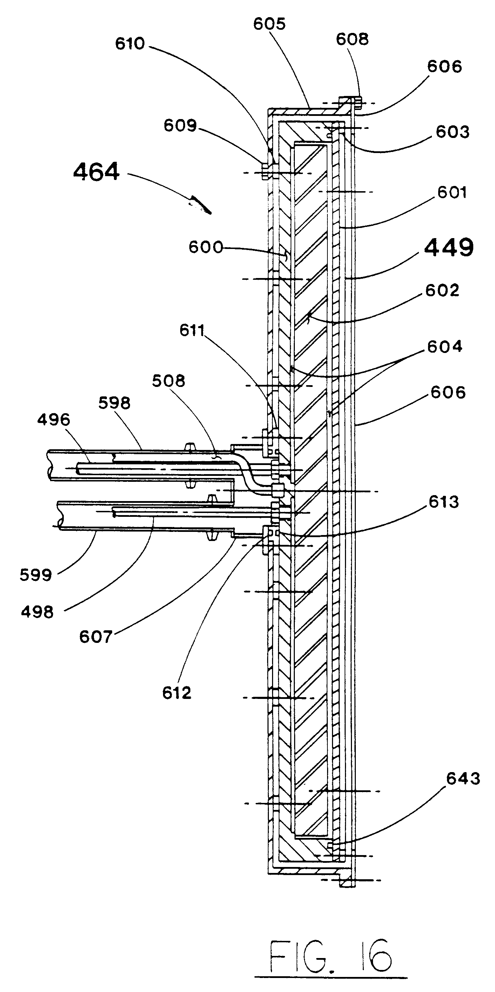

Fig. 16 shows the internally mounted sputtering cathode 449 and corresponding anode 464 as seen in Figures 5, 8, 13 and 15. Internally mounted sputtering cathode 449 is comprised of cathode body 600, sputtering target 601, and magnet 602. Clamp 603 fastens the target 601 to the cathode body 600 and completes their electrical continuity. Lead 508 powers the internally mounted sputtering cathode 449. Cooling water inlet 496 supplies water to the cooling water passage 604 thereby cooling the target 601. Outlet 498 returns the cooling water to the cooling water supply manifold 432 (Fig. 4). O-ring 605 provides a waterproof seal between the target 601 and cathode body 600.

Corresponding sputtering anode 464 comprises an anode body 605, a dark space shield 606 and a utility hub 607. The dark space shield 606 restricts the plasma discharge to the target 601. The dark space shield is affixed to the anode body 605 by means of screws 608. The sputtering anode 464 is insulated from the internally mounted sputtering cathode 449 by means of insulators 610, 'Teflon' (trademark) bolts 609, and insulating ring 611. O-rings 612 and 613 maintain a vacuum seal between utility conduits 598 and 599 and the vacuum chamber 421.

Fig. 17 shows the internally mounted CAPD cathode 424 as seen in Figures 4, 8, 13, and 15. Internally mounted CAPD cathode 424 is comprised of cathode body 614, CAPD target 615, target edge insulating strip 616, cathode body insulation 617, cathode shroud 618, and magnet 530. Cathode shroud 618 is insulated from the cathode body 614 by means of insulators 619, 620 and 621 and 'Teflon' screws 622. Target edge insulating strip 616 is fastened to the CAPD target 615 by means of insulating fasteners 623. O-ring 624 provides a vacuum and water seal between the cathode body 614 and the CAPD target 615. Cooling water passage 625 is supplied with cooling water from inlet 591, thereby cooling the CAPD target 615. Outlet 592 returns the cooling water to the cooling water supply manifold 432. O-rings 626, 627, 628, 629, 630 and 631 maintain a vacuum seal between the cathode body 614 and cathode shroud 618 and the utility cables 596, 597 and 632. Utility cables 596, 597 and 632 connect to the cathode shroud 618 by means of connection hubs 633, 634 and 635.

Power to the electromagnet 530 is supplied by cable 531. Gasket 636 maintains a water-tight seal between the electromagnet 530 and the cathode body 614. Power to the CAPD cathode 424 is supplied by lead 637 and 638 via connectors 639 and 640. Insulating sleeves 641 and 642 insulate connectors 639 and 640 from the cathode shroud 618.

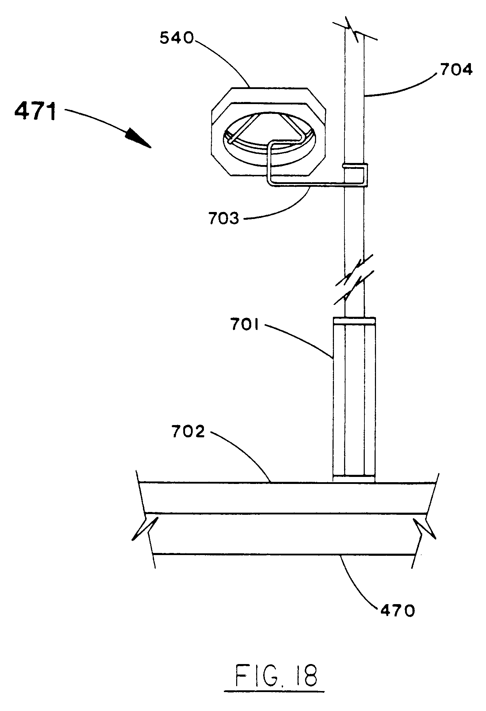

Referring next to Fig. 18 the substrate turntable 470 has a mounting surface 702 which supports the substrate mounting fixture 471. The substrate mounting fixture 471 further comprises a base column 701, and a variable length rod 704. A substrate clamp 703 is affixed to the variable length rod 704. Substrate clamp 703 has a flexible spring consistency. A triangular shape supports the substrate 540 in three spots. A ring, bracelet, earring or similar shaped substrate can be firmly secured with minimal contact against the substrate clamp 703.

Referring next to Fig. 3, the PLC 403 has the following basic hardware capabilities:
- Memory for storage of an operating system;
- Memory for storage of a process program;
- Logic module for process program execution, and
- Logic module for input/output control.
The PLC software 404 has the following basic functional capabilities:
- An operating system for controlling the PLC hardware, and
- A process program ladder logic module.

Referring next to Fig. 19 block 1000 shows the PLC operating system starting up and checking hardware diagnostics to ensure a fully functional PLC exists before proceeding further.

Block 1001 shows the PLC reading all of the dual coating system 400 signal inputs including substrate temperature transmitter 545, cooling water safety switch 435 status, enclosure panels 414, 415, 416, 417, 418, 419 and 420 status, thermocouple sensor 518 measuring vacuum pressure, ion tube 519, pirani gauge sensor 517, valve control panel 551, drive motor 473 speed indicator/controller 553, manual/automatic selector switch 554, CAPD or sputtering process master start switch 556, selector switch 562, process termination switch 557, cooling water safety switch 435, enclosure safety switch 560, voltage and amperage indicators 564, 565, 566, and 567, CAPD cathode selector switches 568 and 569, substrate bias control module 572, internal sputtering power supply 410, door mounted sputtering cathode power control module 574, power indicators 853 and 854, capacitance manometer sensor 492, and the process gas controller 578.

Block 1002 shows the PLC 403 receiving variable recipe data from either the PC 405 or PLC input module 582.

Additionally the PLC 403 can send data to the PC 405 or to the PLC input module 582.

Block 1003 checks for a safe system including cooling water safety switch 435 status, enclosure panels 414, 415, 416, 417, 418, 419 and 420 all closed, and the thermocouple gauge indicator 548 which must show a vacuum exists before proceeding further. Therefore, the program logic first assures that the dual coating system 400 has adequate water flow and has all safety covers in place and has all doors and openings sealed thereby ensuring a secured vacuum chamber 421.

Block 1004 shows the logic for the sequencing of the mechanical pump 452, diffusion pump 451 and the cryogenic trap 489.

Block 1005 shows the logic for selecting whether to proceed with CAPD or sputtering by reading selector switch 562.

Block 1006 shows the logic for controlling the CAPD process gas by means of the process gas controller 578 which controls the mass flow control valves 427, and variable input process parameters from Block 1002. The PLC logic generates an error signal for pressure deviating from set point, and adjusts the mass flow control valves 427 accordingly.

Block 1007 shows the first process specific step for the CAPD process. This first step requires enabling the CAPD power supplies 408 and/or 852. Next the CAPD magnet 530 is enabled. Next the substrate bias power supply 409 is enabled. Next the substrate turntable 470 is activated. Next the substrate bias power supply 409 is controlled to the command voltage as received from block 1002. Next the arc starter(s) 426, 465 ignite the arc(s).

The user has inputted a substrate temperature parameter into block 1002. Now in block 1008 the substrate temperature is brought up to setpoint by means of varying the CAPD power supplies 408 and 852, and the substrate bias power supply 409.

Blocks 1009, 1010, 1011, 1012 execute time versus power consumption and substrate temperature setpoint recipes which have been input into block 1002.

Block 1012 terminates the CAPD process after a predetermined amp hour setpoint as received from block 1002.

Block 1013 dictates whether to proceed with a sputtering process as predetermined from block 1002.

Block 1014 proceeds to an orderly shutdown by allowing the internal chamber pipes 437 to cool the substrate 540 to a predetermined temperature as dictated by block 1002.

Block 1015 executes either an atmospheric vent by opening vent valve 494, or by introducing process gas by means of process gas control valves 427.

The sputtering process is started in block 1016 by introducing process gases by means of the process gas controller 578.

Next Blocks 1017, 1018 move the sputtering cathode shields 513, 514 in front of the sputtering cathodes 464 and 463. Block 1017 proceeds to power the sputtering power supplies 410, 575 in order to sputter clean the sputtering target/cathodes 449 and 460. Time duration for sputter cleaning is dictated by block 1002.

Next block 1019 removes the sputtering cathode shields 513 and 514 away from the sputtering target cathodes 449 and 460. The substrate turntable 470 is activated.

Next block 1020 sputters for a predetermined time and sputtering power supplies 410, 575 supply power output as determined by block 1002.

Sputtering terminates with blocks 1014 and 1015.

Block 1100 shows the PC running executive software and receiving variable process recipes. Variable process recipes include all time, temperature, power, flow and pressure variables the user desires for his process. Block 1101 shows the CRT on the PC displaying the variable input recipes. An optional print output block 1102 is shown. Alternatively the variable process recipes may be entered by means of the PLC input module 582.

Block 1103 shows the PC translating the variable input recipes from engineering units to PLC format data. Block 1104 shows the PC 405 storing and retrieving the variable input recipes.

Block 1105 controls all PC/PLC communications. Block 1106 shows the PLC 403 receiving the variable input recipes. Additionally the PLC 403 can be commanded by the PC 405 to transmit measured process parameters for display and storage by the PC 405.

Variable process recipes can be input into block 1100 concurrently with the execution of measured process parameter displays and storage in blocks 1101, 1102 and 1104.

The best mode for practicing the above noted computer art utilizes a Texas Instruments Series 500 PLC Model 530 C-1102. The PC used herein is an IBM (or compatible) using a Microsoft operating system, MS-DOS, and EGA/VGA graphics. EGA/VGA graphics allow sixteen color displays, primitives and text. Asynchronous serial communications between the PLC and the PC utilize Texas Instruments Task Codes and assembly language routines.

The PLC ladder logic software is written using the Texas Instruments Tisoft Ladder Editor. The PC executive software is written in the "C" language using a Microsoft C compiler.

The executive software for the PC is menu-driven, thereby allowing the screen to prompt the user into entering variable recipes in engineering units. On line "help" prompts are available to the user as an exit from all screens. The executive software accepts all data in engineering units and converts all data to PLC machine readable data using "C" language subroutines.

The CRT block 1101, printer block 1102 and disk block 1104 can receive and display or print or store all variable input process parameters in real time.

## Claims

1. Apparatus for coating a substrate, comprising:
(a) a vacuum chamber (1);
(b) a pumping system (2) for creating a vacuum inside the vacuum chamber;
(c) means for mounting the substrate (8) inside the vacuum chamber;
(d) a sputtering target/cathode (4) with an erosion face (23);
(e) magnet means (20) located adjacent to the sputtering target/cathode on the side thereof remote from the erosion face;
(f) a sputtering anode (5) for generating a plasma discharge for the sputtering target/cathode;
(g) a sputtering power supply (6) for generating an electric circuit between the sputtering target/cathode and its anode;
(h) means (3) for introducing, and controlling the pressure of, a process gas in the vacuum chamber to cause a glow discharge between the sputtering target/cathode and the anode, thereby vaporizing the erosion face and depositing a sputtered coating on the substrate;
(i) a cathodic arc plasma deposition (CAPD) target/cathode (40) having an erosion face;
(j) a CAPD anode (50) for the CAPD target/cathode, with both the CAPD means and the magnetron sputtering means being within the same vacuum chamber;
(k) a CAPD power supply (60) for generating an electric circuit between the CAPD target/cathode and its anode;
(l) means (44) for starting an arc between the CAPD target/cathode and CAPD anode to cause an arc spot on the erosion face, thereby vaporizing the CAPD target/cathode erosion face and depositing a thin coating of CAPD cathode material on the substrate, and
(m) means for sequentially controlling the application of at least two thin film coatings on the substrate.

2. The apparatus as claimed in Claim 1, further comprising:
(a) means (70) for electrically biasing the substrate;
(b) means for measuring the substrate electrical bias;
(c) means for measuring the power of the sputtering power supply;
(d) means for controlling the process gas pressure;
(e) means for measuring the substrate temperature;
(f) means for controlling the substrate temperature;
(g) means for measuring the power of the CAPD power supply, and
(h) means for cooling the vacuum chamber and the sputtering target/cathode and the caps target/cathode.

3. The apparatus as claimed in Claim 1 or 2, further comprising a turntable in the vacuum chamber, which turntable is in electrical continuity with the substrate; and an upright substrate support stand on the turntable.

4. The apparatus as claimed in Claim 3, wherein the upright support stand further comprises a clamp having a spring which contacts the substrate.

5. The apparatus as claimed in Claim 3 or 4, further comprising a substrate bias power supply; a rotary vacuum seal for the turntable; and interconnecting power connections.

6. The apparatus as claimed in any preceding Claim, wherein the means for introducing and controlling a process gas includes a capacitance manometer, a mass flow controller, a mass flow gas control valve, and a throttle valve.

7. The apparatus as claimed in Claim 6, wherein the means for introducing and controlling the process gas includes an upstream pressure control loop.

8. The apparatus as claimed in Claim 6, wherein the means for introducing and controlling the process gas includes a downstream pressure control loop.

9. The apparatus as claimed in Claim 2, further comprising an infrared sensor; and an indicator for measuring the substrate temperature.

10. The apparatus as claimed in any preceding Claim, further comprising means to vary the rate of CAPD sputtering; means to vary the power of the substrate bias power supply, and means to vary the speed of the turntable.

11. The apparatus as claimed in any preceding Claim, further comprising interconnected cooling water pipes for cooling the vacuum chamber; the sputtering target/cathode, and the CAPD target/cathode.

12. The apparatus as claimed in any preceding Claim, wherein the pumping system further comprises a mechanical pump, a diffusion pump and a cryogenic trap.

13. The apparatus as claimed in any preceding Claim, further comprising a substrate with an array of work-pieces having two or more sides.

14. The apparatus as claimed in any preceding Claim, comprising a second sputtering target/cathode and a second CAPD target/cathode, so that the substrate can be simultaneously coated on both sides with material from either both sputtering target/cathodes or both CAPD target cathodes.

15. The apparatus as claimed in any preceding Claim, wherein the sputtering target/cathode further comprises movable shields for protecting the sputtering target/cathode from being coated while the CAPD target/cathode is operating.

16. The apparatus as claimed in any preceding Claim, including a droplet shield having a location in front of the CAPD target/cathode erosion face, thereby preventing droplets from reaching the substrate.

17. The apparatus as claimed in any preceding Claim, wherein the CAPD cathode comprises titanium, zirconium or carbon.

18. A method for depositing multiple thin film coatings in succession on a substrate (8), comprising the steps of:
(a) placing the substrate in a chamber (1);
(b) evacuating the chamber;
(c) activating a cathodic arc plasma deposition (CAPD) target/cathode (40) in the chamber;
(d) depositing a thin film on the substrate of material from the cathode;
(e) injecting a process gas into the chamber;
(f) activating a magnetron sputtering target/cathode (4) in the chamber;
(g) creating a plasma discharge in the chamber; and
(h) depositing a thin sputtered film on the coated substrate.

19. The method as claimed in Claim 18, comprising the further steps of:
(i) cooling the chamber, and
(j) controlling all the foregoing process steps by means of a computer system.

20. The method as claimed in Claim 18 or 19, comprising the step of:
shielding the CAPD droplets from the substrate.

21. The method as claimed in any of Claims 18 to 20, further comprising the step of:
choosing the composition of the CAPD cathode, controlling the CAPD deposition conditions such that the respective film is of substantially the same lustre and colour as gold.

22. The method as claimed in any of Claims 18 to 21, comprising the step of:
controlling the sputtering conditions so that the respective film is firmly adhered to the thin CAPD film.

23. The method as claimed in any of Claims 18 to 22, wherein the chamber vacuum is not broken between the CAPD deposition and the sputtering deposition except by injection of process gas.

## Patentansprüche

1. Apparat zum Beschichten eines Substrats, bestehend aus
(a) einer Vakuumkammer (1),
(b) einem Pumpensystem (2) zum Erzeugen eines Vakuums innerhalb der Vakuumkammer,
(c) Teilen zum Installieren des Substrats (8) innerhalb der Vakuumkammer,
(d) einem Zerstäuber-Target oder einer Zerstäuber-Kathode (4) mit einer Erosionsfront (23),
(e) Magneten (20), angeordnet neben dem Zerstäuber-Target bzw. der Zerstäuber-Kathode an der der Erosionsfront abgewandten Seite,
(f) einer Zerstäuber-Anode (5) zur Erzeugung einer Plasmaentladung für das/die Zerstäuber-Target/Kathode,
(g) einem Zerstäuber-Netzteil (6) zur Erzeugung eines elektrischen Stromkreises zwischen dem/der Zerstäuber-Target/Kathode und seiner/ihrer Anode,
(h) Teilen (3) zum Einleiten und Steuern des Drucks eines Betriebsgases in der Vakuumkammer zum Herbeiführen einer Glühentladung zwischen dem/der Zerstäuber-Target/Kathode und der Anode zum Eindampfen der Erosionsfront und Absetzen einer Bedampfungsschicht auf dem Substrat,
(i) einem/einer kathodischen Lichtbogenplasmaabsetzungs- (CAPD) Target/Kathode (40) mit einer Erosionsfront,
(j) einer CAPD-Anode (50) für das/die CAPD-Target/Kathode, wobei sowohl die CAPD-Teile als auch die Magnetron-Zerstäubungsmittel innerhalb der Vakuumkammer angeordnet sind,
(k) einem CAPD-Netzteil (60) zur Erzeugung eines elektrischen Stromkreises zwischen dem/der CAPD-Target/Kathode und seiner/ihrer Anode,
(l) Teilen (44) zum Zünden eines Lichtbogens zwischen dem/der CAPD-Target/Kathode und der CAPD-Anode, um einen Lichtbogenpunkt auf der Erosionsfront zu bilden und dadurch die CAPD-Target-/Kathodenerosionsfront einzudampfen und eine dünne Schicht des CAPD-Kathodenmaterials auf dem Substrat abzusetzen und
(m) Teilen zur sequentiellen Steuerung der Auftragung von wenigstens zwei dünnen Schichten auf dem Substrat.

2. Apparat nach Anspruch 1 mit
(a) Teilen (70), um das Substrat unter eine elektrische Vorspannung zu setzen,
(b) Teilen zum Messen der elektrischen Substratvorspannung,
(c) Teilen zum Messen des Stroms des Zerstäuber∼Netzteils,
(d) Teilen Zum Steuern des Betriebsgasdrucks,
(e) Teilen zum Messen der Substrattemperatur,
(f) Teilen zum Steuern der Substrattemperatur,
(g) Teilen zum Messen des Stroms des CAPD-Netzteils und
(h) Teilen zum Kühlen der Vakuumkammer und des/der Zerstäubungs-Target/Kathode und des/der CAPD-Target/Kathode.

3. Apparat nach Anspruch 1 oder 2 mit einem Drehtisch in der Vakuumkammer, der mit dem Substrat in elektrischer Kontinuität steht und mit einem aufrechten Substrattraggestell auf dem Drehtisch.

4. Apparat nach Anspruch 3, in welchem das aufrechte Traggestell eine Klemmvorrichtung mit einer Feder aufweist, die das Substrat berührt.

5. Apparat nach Anspruch 3 oder 4 mit einem Substratvorspanninngsnetzteil, einer Vakuumdrehdichtung für den Drehtisch und mit vermaschenden Stromverbindern.

6. Apparat nach einem der vorhergehenden Ansprüche, in welchem die Mittel zum Einleiten und Steuern eines Betriebsgases ein kapazitives Manometer, einen Mengenflußregler, ein Mengenfluß-Gassteuerventil und ein Drosselventil enthalten.

7. Apparat nach Anspruch 6, in welchem die Teile zum Einleiten und Steuern des Betriebsgases einen stromaufwärts gelegenen Druck-Regelkreis enthält

8. Apparat nach Anspruch 6, in welchem die Teile zum Einleiten und Steuern des Betriebsgases einen stromabwärtsgelegenen Druck-Regelkreis enthalten.

9. Apparat nach Anspruch 2, in welchem ferner ein Infrarotsensor und ein Indikator zum Messen der Substrattemperatur vorgesehen sind.

10. Apparat nach einem der vorhergehenden Ansprüche, der ferner Mittel zum Verändern der CAPD-Zerstäubungsmenge, Mittel zum Verändern der Stärke des Substratvorspannungs-Netzteils und Mittel zum Verändern der Geschwindigkeit des Drehtisches enthält.

11. Apparat nach einem der vorhergehenden Ansprüche, der ferner miteinander verbundene Kühlwasserrohre zum Kühlen der Vakuumkammer, des/der Zerstäubungs-Targets/Kathode und des/der CAPD-Targets/Kathode aufweist.

12. Apparat nach einem der vorhergehenden Ansprüche, in welchem das Pumpsystem ferner eine mechanische Pumpe, eine Diffusionspumpe und eine Tiefsttemperaturfalle (oder-abscheider) aufweist.

13. Apparat nach einem der vorhergehenden Ansprüche, der ferner ein Substrat mit einer Anordnung von Werkstücken mit zwei oder mehr Seiten aufweist.

14. Apparat nach einem der vorhergehenden Ansprüche, welcher ein(e) zweites/zweite Zerstäubungs-Target/Kathode und ein(e) zweites/zweite CAPD-Target/Kathode aufweist, so daß das Substrat gleichzeitig an beiden Seiten mit Material von entweder beiden Zerstäubungs-Targets bzw. -Kathoden oder beiden CAPD-Targets bzw. -Kathoden beschichtet werden kann.

15. Apparat noch einem der vorhergehenden Ansprüche, in welchem das/die Zerstäubungs-Target/-Kathode ferner bewegbare Abschirmungen zum Schutz des/der Zerstäubungs-Targets bzw. -Kathode vor einer Beschichtung während des Betriebes des/der CAPD-Targets/Kathode aufweist.

16. Apparat nach einem der vorhergehenden Ansprüche, welcher einen Tröpfchenschirm enthält, der vor der Erosionsfront des/der CAPD-Target/Kathode angeordnet ist, wodurch verhindert wird, daß Tröpfchen das Substrat erreichen.

17. Apparat nach einem der vorhergehenden Ansprüche, in welchem die CAPD-Kathode Titan, Zirkonium oder Kohlenstoff aufweist.

18. Verfahren zum Absetzen mehrerer dünner Schichten nacheinander auf einem Substrat (8) mit folgenden Schritten;
(a) Anordnen des Substrats in einer Kammer (1),
(b) Evakuierung der Kammer,
(c) Aktivierung eines/einer kathodischen Lichtbogenplasmaabsetz (CAPD) -Target/Kathode (40) in der Kammer,
(d) Absetzen eines dünnen Films auf dem Substrat vom Material der Kathode,
(e) Einspritzen eines Betriebsgases in die Kammer,
(f) Aktivierung eines/einer Magnetron-Zerstäubungs-Targets/Kathode (4) in der Kammer,
(g) Schaffung einer Plasmaentladung in der Kammer und
(h) Absetzen eines dünnen Zerstäubungsfilms auf dem beschichteten Substrat.

19. Verfahren nach Anspruch 18 mit folgenden weiteren Schritten:
(i) Kühlen der Kammer und
(j) Steuerung aller vorhergehenden Verfahrensschritte durch Teile eines Computersystems.

20. Verfahren nach Anspruch 18 oder 19, welches den Schritt des Abschirmens der CAPD-Tröpfchen von dem Substrat aufweist.

21. Verfahren nach einem der Ansprüche 18 bis 20 mit dem weiteren Schritt:
Auswahl der Zusammensetzung der CAPD-Kathode, Steuerung der CAPD-Beschichtungsverhältnisse derart, daß der entsprechende Film von im wesentlich demselben Glanz und derselben Farbe wie Gold ist.

22. Verfahren nach einem der Ansprüche 18 bis 21 mit folgendem Schritt:
Steuerung der Zerstäubungszustände derart, daß der entsprechende Film fest an dem dünnen CAPD-Film haftet.

23. Verfahren noch einem der Ansprüche 18 bis 22, bei welchem das Kammervakuum zwischen der CAPD- und der Zerstäubungsablagerung nicht unterbrochen wird, ausgenommen beim Einspritzen des Betriebsgases.

## Revendications

1. Appareil pour revêtement d'un substrat, comprenant :
(a) une chambre à vide (1) ;
(b) un système de pompage (2) pour créer un vide à l'intérieur de la chambre à vide ;
(c) des moyens pour monter le substrat (8) à l'intérieur de la chambre à vide ;
(d) une cathode/cible de pulvérisation (4) ayant une face d'érosion (23) ;
(e) un moyen d'aimant (20) situé de façon adjacente à la cathode/cible de pulvérisation sur son côté éloigné de la face d'érosion ;
(f) une anode de pulvérisation (5) pour produire une décharge plasma pour la cathode/cible de pulvérisation;
(g) une alimentation électrique de pulvérisation (6) pour générer un circuit électrique entre la cathode/cible de pulvérisation et son anode ;
(h) des moyens (3) pour introduire, et en contrôler la pression, un gaz de traitement dans la chambre à vide pour provoquer une décharge luminescente entre la cathode/cible de pulvérisation et l'anode, vaporisant ainsi la face d'érosion et déposant un revêtement pulvérisé sur le substrat ;
(i) une cathode cible (40) de dépôt cathodique par plasma d'arc (CAPD) comportant une face d'érosion ;
(j) une anode de CAPD 50 pour la cathode/cible de CAPD, le moyen de CAPD et le moyen de pulvérisation par magnétron étant tous les deux à l'intérieur de la même chambre ;
(k) une alimentation électrique du CAPD (60) pour produire un circuit électrique entre la cathode/cible de CAPD et son anode ;
(l) des moyens 44) pour amorcer un arc entre la cathode/cible de CAPD et l'anode de CAPD pour provoquer un spot d'arc sur la face d'érosion, vaporisant ainsi la face d'érosion de la cathode/cible de CAPD et déposant un revêtement mince du matériau de cathode de CAPD sur le substrat, et
(m) un moyen pour contrôler séquentiellement l'application d'au moins deux revêtements de film mince sur le substrat.

2. Appareil selon la revendication 1, comprenant de plus :
(a) un moyen (70) pour polariser électriquement le substrat ;
(b) un moyen pour mesurer la polarisation électrique du substrat ;
(c) un moyen pour mesurer la puissance de l'alimentation électrique de pulvérisation ;
(d) un moyen pour contrôler la pression de gaz du processus ;
(e) un moyen pour mesurer la température du substrat;
(f) un moyen pour contrôler la température du substrat ;
(g) un moyen pour mesurer la puissance de l'alimentation électrique de CAPD , et
(h) un moyen pour refroidir la chambre à vide et la cathode/cible de pulvérisation et la cathode/cible de CAPD.

3. Appareil selon la revendication 1 ou 2, comprenant de plus, un plateau tournant dans la chambre à vide, lequel plateau tournant est en continuité électrique avec le substrat ; et un montant vertical de support de substrat sur le plateau tournant .

4. Appareil selon la revendication 3 , dans lequel le montant vertical de support comprend en outre une fixation comportant un ressort qui entre en contact avec le substrat.

5. Appareil selon la revendication 3 ou 4, comprenant, de plus, une alimentation électrique de polarisation du substrat ; un joint à vide rotatif pour le plateau tournant ; et des liaisons électriques d' interconnexion.

6. Appareil selon l'une quelconque des revendications précédentes, dans lequel le moyen pour introduire et contrôler un gaz de traitement inclut un manomètre à capacité, un contrôleur de flux massique, une vanne de commande de gaz du flux massique et une vanne à étranglement.

7. Appareil selon la revendication 6, dans lequel le moyen pour introduire et contrôler le gaz de traitement comprend une boucle de commande de pression en amont .

8. Appareil selon la revendication 6, dans lequel le moyen pour introduire et contrôler le gaz de traitement comprend une boucle de commande de pression en aval.

9. Appareil selon la revendication 2, comprenant de plus un détecteur à infrarouges ; et un indicateur pour mesurer la température du substrat .

10. Appareil selon l'une quelconque des revendications précédentes , comprenant de plus un moyen pour faire varier la vitesse de pulvérisation de CAPD ; un moyen pour faire varier la puissance de l'alimentation électrique de pulvérisation de substrat, et un moyen pour faire varier la vitesse du plateau tournant .

11. Appareil selon l'une quelconque des revendications précédentes, comprenant en outre des tuyaux d'eau de refroidissement interconnectés pour refroidir la chambre à vide ; la cathode/cible de pulvérisation , et la cathode/cible de CAPD.

12. Appareil selon l'une quelconque des revendications précédentes, dans lequel le système de pompage comprend en outre une pompe mécanique, une pompe à diffusion et un piège cryogénique.

13. Appareil selon l'une quelconque des revendications précédentes, comprenant de plus un substrat présentant un arrangement de pièces à usiner comportant deux côtés ou plus.

14. Appareil selon l'une quelconque des revendications précédentes , comprenant une seconde cathode/cible de pulvérisation et une seconde cathode/cible de CAPD, de sorte que le substrat peut être simultanément recouvert sur les deux côtés avec un matériau venant , soit des deux cathodes/cibles de pulvérisation, soit des deux cathodes/cibles de CAPD.

15. Appareil selon l'une quelconque des revendications précédentes, dans lequel la cathode/cible de pulvérisation comprend, de plus, des écrans mobiles pour protéger la cathode/cible de pulvérisation contre un revêtement alors que la cathode/cible de CAPD est en fonctionnement.

16. Appareil selon l'une quelconque des revendications précédentes, comprenant une protection contre les gouttes ayant une position faisant face à la face d'érosion de la cathode/cible de CAPD , évitant ainsi aux gouttelettes d'atteindre le substrat.

17. Appareil selon l'une quelconque des revendications précédentes dans lequel la cathode de CAPD comprend du titane, du zirconium ou du carbone.

18. Procédé pour déposer des revêtements multiples successifs de films minces sur un substrat (8),comprenant les étapes consistant à :
(a) placer le substrat dans une chambre (1) ;
(b) faire le vide dans la chambre ;
(c) activer une cathode/cible de dépôt cathodique par plasma d'arc (CAPD) (40) dans la chambre ;
(d) déposer un film mince sur le substrat du matériau venant de la cathode ;
(e) injecter un gaz de traitement dans la chambre;
(f) activer une cathode/cible de pulvérisation par magnétron (4) dans la chambre;
(g) créer une décharge plasma dans la chambre ; et
(h) déposer un film mince pulvérisé sur le substrat recouvert .

19. Procédé selon la revendication 18, comprenant les étapes supplémentaires consistant à :
(i) refroidir la chambre , et
(j) contrôler toutes les étapes du processus précédent à l'aide d'un système d'ordinateur .

20. Procédé selon la revendication 18 ou 19, comprenant l'étape consistant à :
protéger le substrat des gouttelettes de CAPD.

21. Procédé selon l'une quelconque des revendications 18 à 20, comprenant de plus l'étape consistant à :
choisir la composition de la cathode de CAPD, contrôler les conditions de dépôt de CAPD de sorte que le film respectif soit sensiblement du même brillant et de la même couleur que l'or.

22. Procédé selon l'une quelconque des revendications 18 à 21, comprenant l'étape consistant a:
contrôler les conditions de pulvérisation de sorte que le film respectif adhère solidement au film mince CAPD.

23. Procédé selon l'une quelconque des revendications 18 à 22, dans lequel le vide de la chambre n'est pas cassé entre le dépôt par CAPD et le dépôt par pulvérisation, sauf lors de l'injection du gaz de traitement.
